# EUROPEAN PATENT APPLICATION

(11) **EP 4 697 887 A1**
(43) Date of publication of application: **18.02.2026**
(21) Application number: 25190926.3
(22) Date of filing: 22.07.2025
(51) Int. Cl.: H10B 43/10, H10B 43/27, H10B 43/50

(54) **SEMICONDUCTOR DEVICES AND DATA STORAGE SYSTEMS INCLUDING THE SAME**

(30) Priority: 05.08.2024 KR 20240103927
(71) Applicant: Samsung Electronics Co., Ltd., Suwon-si, Gyeonggi-do 16677 (KR)
(72) Inventor: PARK, Sangyong, 16677 Suwon-si, Gyeonggi-do (KR); MOON, Kibong, 16677 Suwon-si, Gyeonggi-do (KR); LEE, Sungbok, 16677 Suwon-si, Gyeonggi-do (KR); LEE, Jaeduk, 16677 Suwon-si, Gyeonggi-do (KR)
(74) Representative: Kuhnen & Wacker Patent- und Rechtsanwaltsbüro PartG mbB

(57) **Abstract**

A semiconductor device may include a first semiconductor structure (PERI) including a substrate (201), circuit devices (220) on the substrate (201), a first interconnection structure (270, 280) electrically coupled to the circuit devices (220), and a first bonding metal layer (298) on the circuit devices (220) and the first interconnection structure (270, 280), a second semiconductor structure (CELL) connected to the first semiconductor structure (PERI) on the first semiconductor structure (PERI), and the second semiconductor structure (CELL) including a memory cell substrate including a conductive pattern (101) and an insulating pattern (105) in contact with a side surface of the conductive pattern (101), gate electrodes (130) stacked and spaced apart from each other below the memory cell substrate, channel structures (CHS) penetrating the gate electrodes (130) and spaced apart from each other in a first direction (X), a second interconnection structure (172, 174) below the gate electrodes (130) and the channel structures (CHS), a second bonding metal layer below the second interconnection structure, and the second bonding metal layer (198) connected to the first bonding metal layer (298).

## Description

### BACKGROUND

Some example embodiments of the present disclosure relate to a semiconductor device and a data storage system including the same.

There has been a growing demand for semiconductor devices capable of storing high-capacity data in data storage systems. Accordingly, methods for increasing data storage capacity of semiconductor devices has been researched. For example, methods for increasing the integration density of semiconductor devices, a semiconductor device including memory cells and a peripheral circuit region disposed vertically has been proposed.

### SUMMARY

Some example embodiments of the present disclosure provide a semiconductor device having improved reliability, and a data storage system including the same.

According to some example embodiments of the present disclosure, a semiconductor device may include a first semiconductor structure including a substrate, circuit devices on the substrate, a first interconnection structure electrically coupled to the circuit devices, and a first bonding metal layer on the circuit devices and the first interconnection structure, and a second semiconductor structure connected to the first semiconductor structure on the first semiconductor structure, and the second semiconductor structure including a memory cell substrate including a conductive pattern and an insulating pattern in contact with a side surface of the conductive pattern, gate electrodes stacked and spaced apart from each other in a perpendicular direction below the memory cell substrate, the perpendicular direction being perpendicular to a lower surface of the memory cell substrate, channel structures penetrating the gate electrodes, extending into the memory cell substrate in the perpendicular direction, and the channel structures spaced apart from each other in a first direction, the first direction intersecting the perpendicular direction, a second interconnection structure below the gate electrodes and the channel structures, a second bonding metal layer below the second interconnection structure, and the second bonding metal layer connected to the first bonding metal layer. Each of the channel structures includes a first channel hole penetrating the gate electrodes in the perpendicular direction, a second channel hole penetrating the gate electrodes in the perpendicular direction, the second channel hole spaced apart from the first channel hole, a first channel pattern including a first channel portion in the first channel hole, a second channel portion in the second channel hole, and a first channel connection portion extending from the first channel portion and the second channel portion on the gate electrodes, the first channel connection portion connecting the first channel portion to the second channel portion, and the conductive pattern not overlapping the first channel hole in the perpendicular direction and overlapping the second channel hole in the perpendicular direction.

According to some example embodiments of the present disclosure, a semiconductor device may include a first semiconductor structure including a substrate, circuit devices on the substrate, and a first interconnection structure on the circuit devices, and a second semiconductor structure on the first semiconductor structure, the second semiconductor structure including a memory cell substrate including conductive patterns spaced apart from each other, gate electrodes including an upper select gate electrode, memory gate electrodes, a lower select gate electrode stacked and spaced apart from each other in a perpendicular direction below the memory cell substrate, the perpendicular direction being perpendicular to a lower surface of the memory cell substrate, and the upper select gate electrode, the memory gate electrodes, and the lower select gate electrode being stacked in order from the lower surface of the memory cell substrate, a first isolation structure and a second isolation structure, each of the first and second isolation structures penetrating gate electrodes, extending in a first direction intersecting the perpendicular direction, and spaced apart from each other in a second direction, the second direction intersecting the first direction, first channel structures penetrating the gate electrodes between the first isolation structure and the second isolation structure, extending in the perpendicular direction, and spaced apart from each other in the first direction, second channel structures penetrating the gate electrodes between the first isolation structure and the second isolation structure, extending in the perpendicular direction, and spaced apart from the first channel structures in the second direction, and a second interconnection structure below the gate electrodes and the first and second channel structures. Each of the first channel structures and the second channel structures includes first to fourth channel holes penetrating the gate electrodes in the perpendicular direction and spaced apart from each other, first to fourth data storage patterns in the first to fourth channel holes, and a first channel pattern extending from at least two or more of the first to fourth channel holes, and extending above at least two or more channel holes on the upper select gate electrode, the conductive patterns include a first conductive pattern extending in the first direction and a second conductive pattern spaced apart from the first conductive pattern in the second direction, the first conductive pattern is in contact with a portion of the first channel pattern of each of the first channel structures, and the second conductive pattern is in contact with a portion of the first channel pattern of each of the second channel structures.

According to some example embodiments of the present disclosure, a data storage system may include a semiconductor storage device including a first semiconductor structure including circuit devices, a second semiconductor structure on one surface of the first semiconductor structure, and input/output pads electrically connected to the circuit devices, and a controller electrically connected to the semiconductor storage device through the input/output pad, and the controller configured to control the semiconductor storage device, the second semiconductor structure including a memory cell substrate including a conductive pattern and an insulating pattern surrounding a side surface of the conductive pattern, gate electrodes stacked and spaced apart from each other in a perpendicular direction below the memory cell substrate, the perpendicular direction being perpendicular to a lower surface of the memory cell substrate, and channel structures penetrating the gate electrodes, extending in the perpendicular direction, and the channel structures spaced apart from each other in a first direction, the first direction intersecting the perpendicular direction. Each of the channel structures includes a first channel hole penetrating the gate electrodes in the perpendicular direction, a second channel hole penetrating the gate electrodes in the perpendicular direction, the second channel hole spaced apart from the first channel hole, a first data storage pattern in the first channel hole, a second data storage pattern in the second channel hole, and a channel pattern including a first portion surrounded by the first data storage pattern and the second data storage pattern, a second portion extending from the first portion and extending above the first data storage pattern and the second data storage pattern, a third portion extending from the second portion, and the third portion connecting the second portion of the channel pattern and an adjacent second portion of an adjacent channel pattern to each other, and the second portion of the channel pattern has a width decreasing from a lower surface to an upper surface.

### BRIEF DESCRIPTION OF DRAWINGS

The above and other aspects, features, and advantages of some example embodiments of the present disclosure will be more clearly understood from the following detailed description, taken in combination with the accompanying drawings, in which:
FIG. 1 is a block diagram illustrating a semiconductor device according to some example embodiments of the present disclosure;
FIG. 2 is an equivalent circuit diagram illustrating a memory cell array of the semiconductor device illustrated in FIG. 1 according to some example embodiments of the present disclosure;
FIG. 3 is a plan diagram illustrating a semiconductor device according to some example embodiments of the present disclosure;
FIG. 4 is an enlarged diagram illustrating a cell array region of the semiconductor device illustrated in FIG. 3 according to some example embodiments of the present disclosure;
FIG. 5A is a cross-sectional diagram illustrating a semiconductor device taken along line I-I' in FIG. 4 according to some example embodiments of the present disclosure;
FIG. 5B is an enlarged diagram illustrating region A according to some example embodiments of the present disclosure;
FIG. 6A is a cross-sectional diagram illustrating a semiconductor device taken along line II-II' in FIG. 4 according to some example embodiments of the present disclosure;
FIG. 6B is an enlarged diagram illustrating region B according to some example embodiments of the present disclosure;
FIG. 7 is an enlarged diagram illustrating region A according to some example embodiments of the present disclosure;
FIG. 8 is an enlarged diagram illustrating region B in FIG. 6A according to some example embodiments of the present disclosure;
FIGS. 9 and 10 are enlarged diagrams illustrating a cell array region of the semiconductor device illustrated in FIG. 3 according to some example embodiments of the present disclosure;
FIGS. 11A to 21B are diagrams illustrating a method of manufacturing a semiconductor device according to some example embodiments of the present disclosure;
FIG. 22 is a diagram illustrating a data storage system including a semiconductor device according to some example embodiments of the present disclosure;
FIG. 23 is a perspective diagram illustrating a data storage system including a semiconductor device according to some example embodiments of the present disclosure; and
FIG. 24 is a cross-sectional diagram illustrating a semiconductor package according to some example embodiments of the present disclosure.

### DETAILED DESCRIPTION

Hereinafter, example embodiments of the present disclosure will be described as follows with reference to the accompanying drawings.

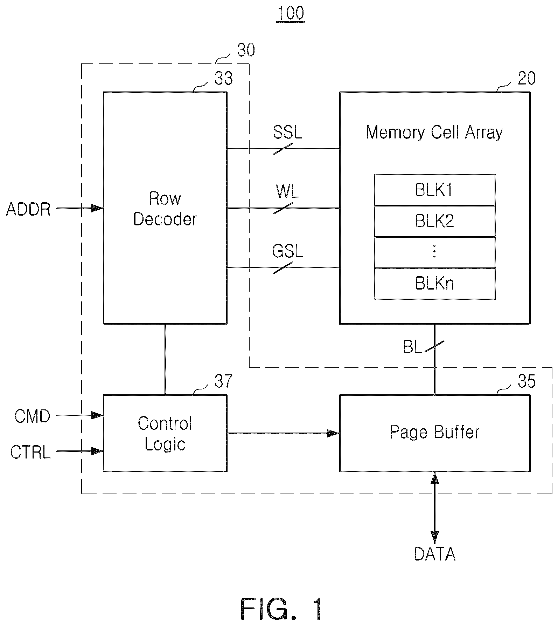

FIG. 1 is a block diagram illustrating a semiconductor device according to some example embodiments.

Referring to FIG. 1, a semiconductor device 100 may be configured such that stored data may be continuously maintained even when power is not supplied. The semiconductor device 100 may be a vertical NAND flash memory device. The semiconductor device 100 may include a memory cell array 20 and a peripheral circuit 30. The memory cell array 20 may include a plurality of memory cell blocks BLK1-BLKn. Each of the memory cell blocks BLK1-BLKn may include a plurality of memory cells. The memory cell array 20 may be connected to the peripheral circuit 30 through a bit line BL, a word line WL, at least a string select line SSL, and at least one ground select line GSL. Specifically, the memory cell blocks BLK1-BLKn may be connected to a row decoder 33 through the word line WL, the string select line SSL, and the ground select line GSL. Also, the memory cell blocks BLK1-BLKn may be connected to the page buffer 35 through the bit line BL.

The peripheral circuit 30 may receive an address ADDR, a command CMD, and a control signal CTRL from an external entity present externally of the semiconductor device 100, and may transmit data DATA to and receive data DATA from an external device present externally of the semiconductor device 100. The peripheral circuit 30 may include a control logic 37, a row decoder 33, and a page buffer 35. Although not illustrated, the peripheral circuit 30 may further include various sub-circuits among an input/output circuit, a voltage generator circuit generating various voltages utilized for operation of the semiconductor device 100, and an error correction circuit for correcting errors in the data DATA read out from the memory cell array 20.

The control logic 37 may be connected to the row decoder 33, the input/output circuit, and the voltage generator circuit. The control logic 37 may control overall operations of the semiconductor device 100. The control logic 37 may generate various internal control signals used in the semiconductor device 100 in response to the control signal CTRL. For example, the control logic 37 may adjust voltage levels provided to the word line WL and the bit line BL when a memory operation such as a program operation or an erase operation is performed.

The row decoder 33 may select at least one of a plurality of memory cell blocks BLK1-BLKn in response to the address ADDR, and may select at least one word line WL, at least one string select line SSL, and at least one ground select line GSL of the selected memory cell blocks BLK1-BLKn. Also, the row decoder 33 may transfer a voltage for performing a memory operation to the word line WL of the selected memory cell blocks BLK1-BLKn.

The page buffer 35 may be connected to the memory cell array 20 through the bit line BL. The page buffer 35 may operate as a write driver or a sense amplifier. Specifically, when a program operation is performed, the page buffer 35 may operate as a write driver and may apply a voltage according to the data DATA to be stored in memory cell array 20 to the bit line BL. When a read operation is performed, the page buffer 35 may operate as a sense amplifier and may sense the data DATA stored in the memory cell array 20.

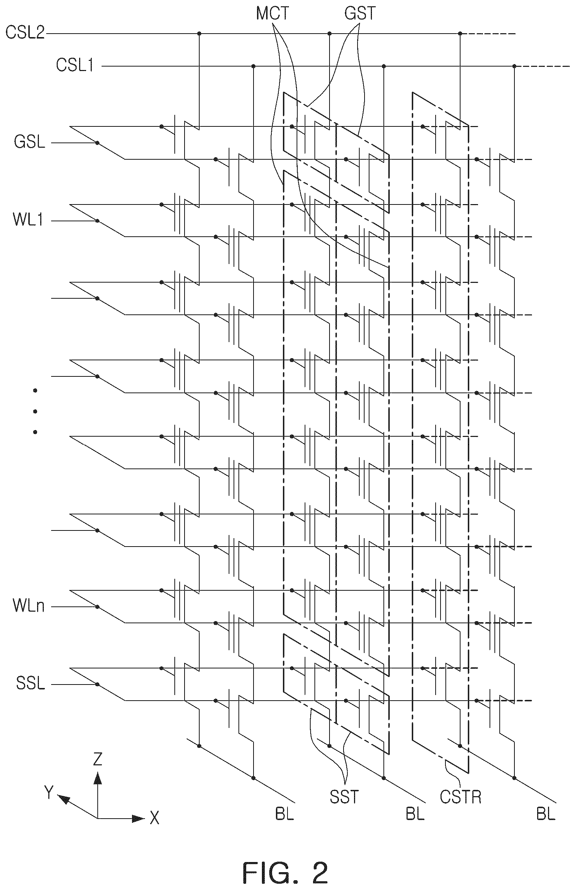

FIG. 2 is an equivalent circuit diagram illustrating a memory cell array of the semiconductor device illustrated in FIG. 1 according to some example embodiments.

Referring to FIG. 2, the memory cell array 20 of the semiconductor device 100 may include common source lines CSL1 and CSL2, a plurality of bit lines BL and a plurality of cell strings CSTR.

The plurality of common source lines CSL1 and CSL2 may be arranged two-dimensionally. For example, the plurality of common source lines CSL1 and CSL2 may be spaced apart from each other in the second direction (Y-direction) and may extend in the first direction (X-direction). The common source lines CSL1 and CSL2 may be electrically applied with the same voltage or may be applied with different voltages and may be controlled separately. The plurality of common source lines CSL1 and CSL2 extending in the first direction (X-direction) may be connected to ground select transistors GST disposed in the same row. The ground select transistors GST disposed in the same row may be connected to different bit lines BL.

A plurality of bit lines BL may be arranged two-dimensionally. For example, a plurality of bit lines BL may be spaced apart from each other in the first direction (X-direction) and may extend in the second direction (Y-direction). A plurality of cell strings CSTR may be connected to the bit lines BL in parallel, respectively. The cell strings CSTR may be individually connected to the common source lines CSL1 and CSL2, respectively. That is, the plurality of cell strings CSTR may be disposed between the bit line BL and the common source lines CSL1 and CSL2.

Each of the plurality of cell strings CSTR may include ground select transistors GST in contact with corresponding common source lines CSL1 and CSL2, respectively, string select transistors SST in contact with corresponding bit lines BL, and a plurality of memory cell transistors MCT disposed between ground select transistors GST and string select transistors SST. The plurality of memory cell transistors MCT may include memory cells corresponding to the word lines WL1-WLn. Each of the memory cell transistors MCT may include a data storage element. The ground select transistors GST, the string select transistors SST, and the memory cell transistors MCT may be connected to each other in series in the third direction (Z-direction).

The common source lines CSL1 and CSL2 may be connected to sources of the ground select transistors GST, respectively. The ground select line GSL, the plurality of word lines WL1-WLn and the string select line SSL may be disposed between the common source lines CSL1 and CSL2 and the bit lines BL. The ground select line GSL may be used as a gate electrode of each of the ground select transistors GST, the plurality of word lines WL1-WLn may be used as gate electrodes of each of the memory cell transistors MCT, and the string select line SSL may be used as a gate electrode of each of the string select transistors SST.

The memory cell transistors MCT may be connected to a common ground select line GSL and a common string select line SSL. The string select line SSL may be connected to memory cell transistors MCT connected to the bit line BL. The memory cell strings CSTR may be connected to the string select line SSL.

In terms of circuit operation of the semiconductor device 100, a row decoder (e.g., row decoder 33 in FIG. 1) may select one of a plurality of memory blocks (e.g., a plurality of the memory cell blocks BLK1-BLKn in FIG. 1) based on a row address, may select one of the word lines WL1-WLn of the selected memory block, and may select one of the common source lines CSL1 and CSL2.

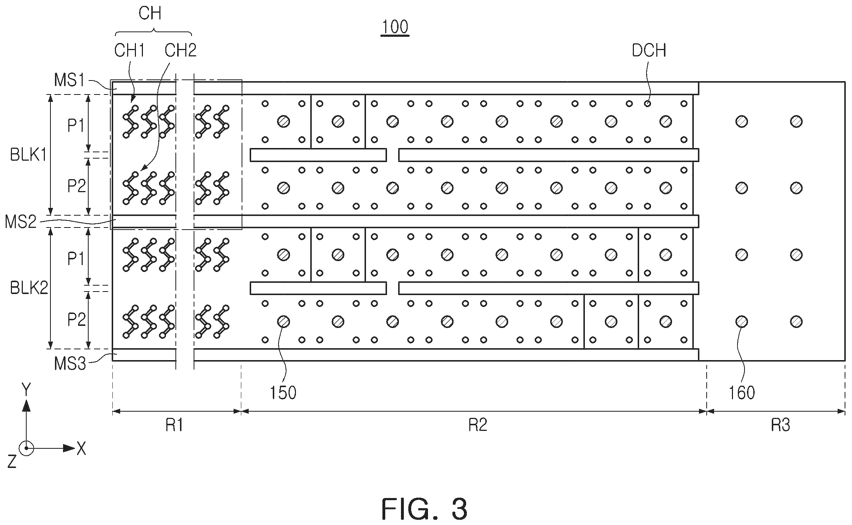

FIG. 3 is a plan diagram illustrating a semiconductor device according to some example embodiments.

Referring to FIG. 3, a semiconductor device 100 may include a cell array region R1, an extension region R2, and a pad region R3.

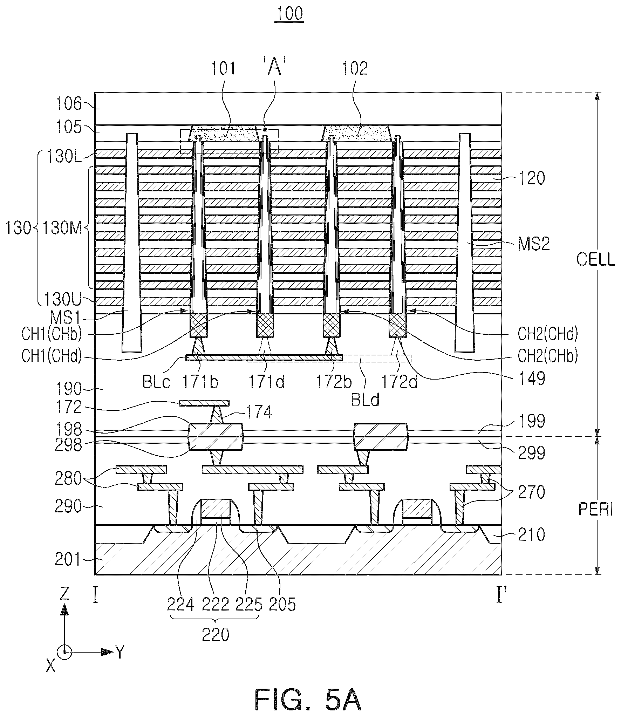

A memory cell array including a plurality of memory cells (e.g., memory cell array 20 in FIG. 1) may be formed in the cell array region R1. For example, channel structures CH, bit lines (e.g., the bit lines BL in FIG. 2), common source lines (e.g., the common source lines CSL1 and CSL2 in FIG. 2), gate electrodes (e.g., the gate electrodes 130 in FIG. 5A) may be disposed in the cell array region R1.

Isolation structures MS1 and MS2, and MS3 may be further disposed in the cell array region R1. In some example embodiments, each of the isolation structures MS1 and MS2, and MS3 may penetrate the gate electrodes and may extend in the first direction (X-direction). The isolation structures MS1 and MS2, and MS3 may extend in the first direction (X-direction) and may be spaced apart from each other in the second direction (Y-direction) as a first isolation structure MS1, a second isolation structure MS2, and a third isolation structure MS3. The first isolation structure MS1, the second isolation structure MS2, and the third isolation structure MS3 may be disposed in parallel to each other in the first direction (X-direction). The memory cell blocks BLK1 and BLK2 may be defined by mold structures isolated from each other by the isolation structures MS1 and MS2, and MS3. For example, the first memory cell block BLK1 may be defined by the first isolation structure MS1 and the second isolation structure MS2, and the second memory cell block BLK2 may be defined by the second isolation structure MS2 and the third isolation structure MS3. In the first and second memory cell blocks BLK1 and BLK2, a plurality of page regions P1 and P2 spaced apart from each other in the second direction (Y-direction) may be disposed. In some example embodiments, each of the first and second memory cell blocks BLK1 and BLK2 may include a first page region P1 and a second page region P2, respectively. In each of the first and second memory cell blocks BLK1 and BLK2, two pages regions, the first and second page regions P1 and P2, may be disposed, but example embodiments are not limited thereto, and three or more plurality of page regions may be disposed in each of the first and second memory cell blocks BLK1 and BLK2. The first page region P1 and the second page region P2 may be defined by word lines (e.g., the word lines WL1-WLn in FIG. 2) included in the first and second memory cell blocks BLK1 and BLK2, respectively.

In each of the first page region P1 and the second page region P2, a plurality of channel structures CH spaced apart from each other in the first direction (X-direction) may be disposed. Each of the plurality of channel structures CH may include a plurality of channel holes extending in the third direction (Z-direction) and penetrating the mold structure. In the drawing, the plurality of channel structures CH may penetrate four channel holes, respectively, but example embodiments are not limited thereto, and in some example embodiments, the plurality of channel structures CH may penetrate two channel holes or four or more channel holes, respectively.

In some example embodiments, in the mold structure, the gate electrodes (e.g., the gate electrodes 130 in FIG. 5A) and the mold insulating layer (e.g., the interlayer insulating layer 120 in FIG. 5A) may be alternately stacked.

The plurality of channel structures CH may include first channel structures CH1 disposed in the first page region P1 and second channel structures CH2 disposed in the second page region P2.

The extension region R2 may be disposed at a periphery of the cell array region R1. The gate electrodes (e.g., the gate electrodes 130 in FIG. 5A) may be stacked in a staircase shape in the extension region R2. The cell contact 150 and the dummy channel structure DCH may be disposed in the extension region R2. The cell contact 150 may extend in the vertical direction (Z-direction) and may be in contact with the gate electrodes (e.g., the gate electrode disposed at an uppermost end of the gate electrodes 130 in FIG. 5A). The dummy channel structure DCH may be formed in a shape similar to a shape of the channel structure CH and may reduce stress applied to the mold structure in the extension region R2.

The pad region R3 may be disposed on an internal side of the cell array region R1 and the extension region R2. The input/output contact 160 may be disposed on the pad region R3. The external device and the semiconductor device 100 may be electrically connected to each other through the input/output contact 160.

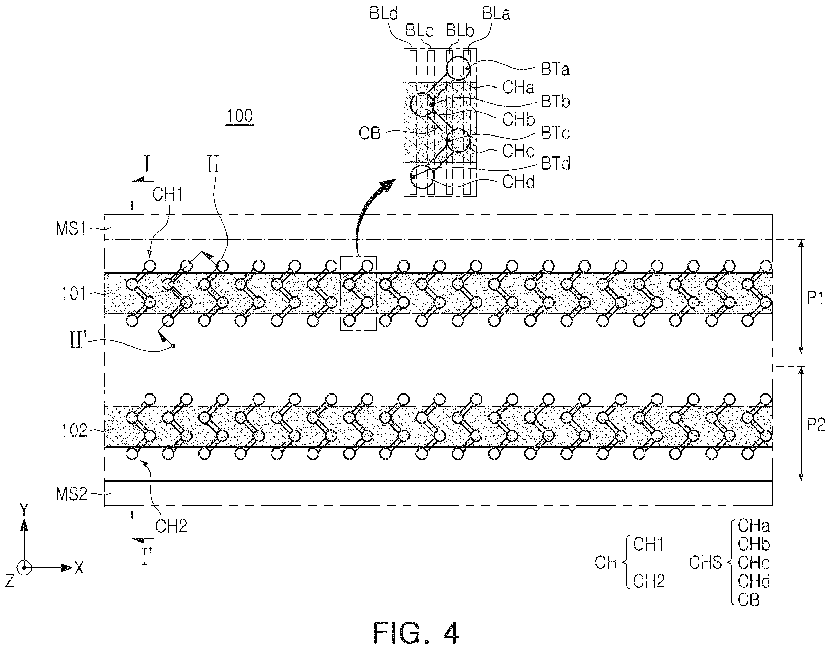

FIG. 4 is an enlarged diagram illustrating a cell array region of the semiconductor device illustrated in FIG. 3 according to some example embodiments.

Referring to FIG. 3 and FIG. 4, FIG. 4 is a plan diagram illustrating a memory cell block among a plurality of memory cell blocks BLK1 and BLK2 of the cell array region R1 of the semiconductor device 100 and the first and second page regions P1 and P2 in the memory cell block.

Referring to FIG. 4, the plurality of channel structures CH may be disposed in each of the first and second page regions P1 and P2 of the semiconductor device 100. The first channel structures CH1 may be disposed in the first page region P1, and the second channel structures CH2 may be disposed in the second page region P2.

Each of the first channel structures CH1 and the second channel structures CH2 may include a plurality of channel structures CHS spaced apart from each other in the first direction (X-direction).

Each of the plurality of channel structures CHS may include first, second, third and fourth channel holes CHa, CHb, CHc, and CHd and a connection pattern CB connecting the first, second, third and fourth channel holes CHa, CHb, CHc, and CHd to each other. In some example embodiments, each of the first, second, third and fourth channel holes CHa, CHb, CHc, and CHd may extend in the third direction (Z-direction) and may penetrate the mold structure. The first, second, third and fourth channel holes CHa, CHb, CHc, and CHd may be arranged alternately in the first direction (X-direction) and the second direction (Y-direction) when viewed on a plane. For example, the first, second, third and fourth channel holes CHa, CHb, CHc, and CHd may be arranged in order in a zigzag pattern in the second direction (Y-direction). In some example embodiments, the connection pattern CB may have a structure extending from the first, second, third and fourth channel holes CHa, CHb, CHc, and CHd, respectively, thereby connecting the first, second, third and fourth channel holes CHa, CHb, CHc, and CHd to each other.

The semiconductor device 100 may be disposed in a cell array region (e.g., the cell array region R1) and may further include first, second, third, and fourth conductive interconnections BLa, BLb, BLc, and BLd connected to the first, second, third, and fourth channel holes CHa, CHb, CHc, and CHd, respectively. The first, second, third, and fourth conductive interconnections BLa, BLb, BLc, and BLd may extend in the second direction (Y-direction) and may be spaced apart from each other in the first direction (X-direction). The first conductive interconnection BLa may overlap the first channel hole CHa in the vertical direction (Z-direction) and may be connected to the first channel hole CHa through the first contact pad BTa. The second conductive interconnection BLb may overlap the third channel hole CHc in the vertical direction (Z-direction) and may be connected to the third channel hole CHc through the third contact pad BTc. The third conductive interconnection BLc may overlap the second channel hole CHb in the vertical direction (Z-direction) and may be connected to the second channel hole CHb through the second contact pad BTb. The fourth conductive interconnection BLd may overlap the fourth channel hole CHd in the vertical direction (Z-direction) and may be connected to the fourth channel hole CHd through the fourth contact pad BTd. The first, second, third, and fourth conductive interconnections BLa, BLb, BLc, and BLd may correspond to the bit lines BL in FIG. 2. In some example embodiments, the first channel hole CHa of each of the first channel structures CH1 and the first channel hole CHa of each of the second channel structures CH2 may be in contact with the common first conductive interconnection BLa. The second channel hole CHb of each of the first channel structures CH1 and the second channel hole CHb of each of the second channel structures CH2 may be in contact with the common third conductive interconnection BLc. The third channel hole CHc of each of the first channel structures CH1 and the third channel hole CHc of each of the second channel structures CH2 may be in contact with the common second conductive interconnection BLb. The fourth channel hole CHd of each of the first channel structures CH1 and the fourth channel hole CHd of each of the second channel structures CH2 may be in contact with the common fourth conductive interconnection BLd.

The semiconductor device 100 may further include a first conductive pattern 101 disposed on a first page region P1 and a second conductive pattern 102 disposed on a second page region P2. In some example embodiments, the first conductive pattern 101 and the second conductive pattern 102 may extend in a first direction (X-direction) and may be spaced apart from each other in the second direction (Y-direction). The first conductive pattern 101 may overlap at least a portion of the first channel structures CH1 on the first channel structures CH1. The second conductive pattern 102 may overlap at least a portion of the second channel structures CH2 on the second channel structures CH2. The first and second conductive patterns 101 and 102 may overlap at least two adjacent channel holes among the first to fourth channel holes CHa-CHd, and may not overlap the other channel holes. In some example embodiments, the first conductive pattern 101 may overlap the second and third channel holes CHb and CHc of the channel structure CHS of the first channel structures CH1, and may be in contact with the channel connection portions overlapping the second and third channel holes CHb and CHc. The second conductive pattern 102 may overlap the second and third channel holes CHb and CHc of the channel structure CHS of the second channel structures CH2, and may be in contact with the channel connection portions overlapping the second and third channel holes CHb and CHc. The first and second conductive patterns 101 and 102 may not overlap the first channel hole CHa and the fourth channel hole CHd. However, example embodiments are not limited thereto, and in some example embodiments, the first and second conductive patterns 101 and 102 may overlap first to third channel holes CHa-CHc and may not overlap fourth channel hole CHd, and the second conductive pattern 102 may overlap the second and third channel holes CHb and CHc and may not overlap the first and fourth channel holes CHa and CHd. The first and second conductive patterns 101 and 102 may correspond to the common source lines CSL1 and CSL2 in FIG. 2.

The first conductive pattern 101 may function as a first common source line CSL1 in FIG. 2, and the second conductive pattern 102 may function as the second common source line CSL2 in FIG. 2.

A semiconductor device according to some example embodiments may include first and second isolation structures MS1 and MS2 extending in the first direction (X-direction) and penetrating the gate electrodes, first and second channel structures CH1 and CH2 disposed between the first and second isolation structures MS1 and MS2, and first and second conductive patterns 101 and 102 on the first and second channel structures CH1 and CH2 and extending in the first direction (X-direction), each of the channel structures CH1 and CH2 may include the channel structures CHS spaced apart from each other in the first direction (X-direction), and each of the channel structures CHS may include a channel pattern extending from a plurality of channel holes and connecting the plurality of channel holes to each other. Accordingly, the first and second conductive patterns 101 and 102 in contact with the first and second channel structures CH1 and CH2, respectively, are disposed on a page basis, and by reducing and/or improving contact defects between the first and second channel structures CH1 and CH2 and the first and second conductive patterns 101 and 102, a semiconductor device having improved electrical properties may be provided.

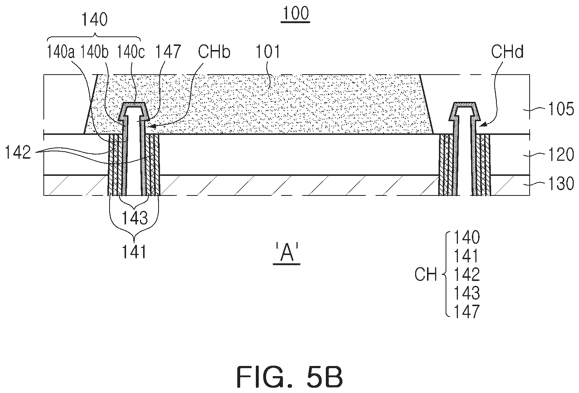

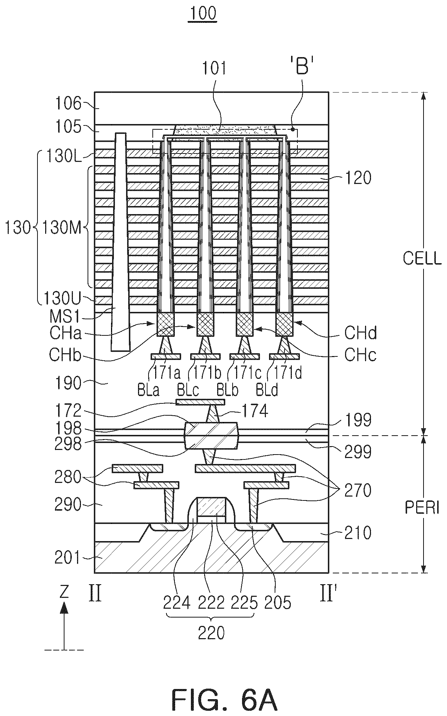

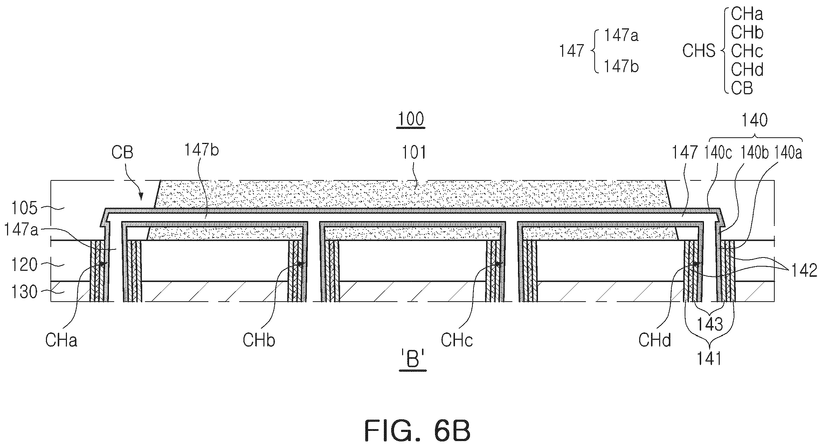

FIG. 5A is a cross-sectional diagram illustrating a semiconductor device taken along line I-I' in FIG. 4 according to some example embodiments. FIG. 5B is an enlarged diagram illustrating region A according to some example embodiments. FIG. 6A is a cross-sectional diagram illustrating a semiconductor device taken along line II-II' in FIG. 4 according to some example embodiments. FIG. 6B is an enlarged diagram illustrating region B according to some example embodiments.

Referring to FIGS. 5A, 5B, 6A, and 6B, the semiconductor device 100 may include a peripheral circuit structure PERI as a first semiconductor structure and a memory cell structure CELL as a second semiconductor structure bonded to each other by a wafer bonding method. That is, the semiconductor device 100 may have a chip to chip (C2C) structure. The C2C structure may indicate that the memory cell structure CELL may be manufactured, the peripheral circuit structure PERI may be manufactured, and the memory cell structure CELL and the peripheral circuit structure PERI may be connected to each other by a bonding method. In some example embodiments, the structure may indicate a method in which a second bonding metal layer 198 formed on a lowermost second bonding insulating layer 199 of the memory cell structure CELL and a bonding metal formed on a first bonding metal layer 298 formed on an uppermost first bonding insulating layer 299 of the peripheral circuit structure PERI may be electrically connected to each other. The memory cell structure CELL may be disposed on the peripheral circuit structure PERI. In some example embodiments, a memory cell structure CELL may be disposed below a peripheral circuit structure PERI.

The peripheral circuit structure PERI may include a substrate 201, an impurity region 205 in the substrate 201, device isolation regions 210, circuit devices 220 on the substrate 201, circuit contact plugs 270, circuit interconnection lines 280, a peripheral region insulating layer 290, and a peripheral bonding structure. The peripheral bonding structure may include a first bonding metal layer 298 and a first bonding insulating layer 299.

The substrate 201 may have an upper surface extending in the first direction (X-direction) and the second direction (Y-direction). An active region may be defined in the substrate 201 by the device isolation regions 210. Impurity regions 205 may be disposed in a portion of the active region, source/drain regions. The substrate 201 may include a semiconductor material, such as a group IV semiconductor, a group III-V compound semiconductor, or a group II-VI compound semiconductor. The substrate 201 may be provided as a bulk wafer or an epitaxial layer. However, example embodiments are not limited thereto.

The circuit devices 220 may include a planar transistor. Each of the circuit devices 220 may include a circuit gate dielectric layer 222, a spacer layer 224, and a circuit gate electrode 225. The impurity regions 205 may be disposed in the substrate 201 on both sides of the circuit gate electrode 225.

The peripheral region insulating layer 290 may be disposed on the circuit devices 220 on the substrate 201. The peripheral region insulating layer 290 may include a plurality of insulating layers formed in different processes. The peripheral region insulating layer 290 may be formed of an insulating material.

The circuit contact plugs 270 and the circuit interconnection lines 280 may form a circuit interconnection structure electrically connected to the circuit devices 220 and the impurity regions 205. The circuit contact plugs 270 may have a cylindrical shape, and the circuit interconnection lines 280 may have a line shape. An electrical signal may be applied to the circuit devices 220 by the circuit contact plugs 270 and the circuit interconnection lines 280. In a region not illustrated, the circuit contact plugs 270 may also be connected to the circuit gate electrode 225. The circuit contact plugs 270 and the circuit interconnection lines 280 may include a conductive material, for example, tungsten (W), copper (Cu), aluminum (Al), and each component may further include a diffusion barrier. However, example embodiments are not limited thereto. The circuit interconnection lines 280 may be connected to the circuit contact plugs 270 and may be disposed in a plurality of layers. In some example embodiments, the circuit contact plugs 270 and the circuit interconnection lines 280 may be referred to as the first interconnection structure.

The first bonding metal layers 298 may be connected to the second bonding metal layers 198 of the memory cell structure CELL. The first bonding metal layers 298, together with the second bonding metal layers 198, may provide an electrical connection path according to the bonding of the memory cell structure CELL and the peripheral circuit structure PERI. Although not illustrated, at least a portion of the first bonding metal layers 298 may be connected to the circuit contact plugs 270 and/or the circuit interconnection lines 280. In some example embodiments, a portion of the first bonding metal layers 298 may not be connected to the circuit contact plugs 270 and/or the circuit interconnection lines 280 and may be disposed only for bonding.

The first bonding metal layers 298 may include a conductive material, for example, copper (Cu). However, example embodiments are not limited thereto. The first bonding insulating layer 299 may be disposed around the first bonding metal layers 298. The first bonding insulating layer 299 may also function as a diffusion barrier for the first bonding metal layers 298 and may include, for example, at least one of SiN, SiON, SiCN, SiOC, SiOCN, or SiO. However, example embodiments are not limited thereto.

The memory cell structure CELL may include first and second conductive patterns 101 and 102, insulating pattern 105 surrounding side surfaces of the first and second conductive patterns 101 and 102, a passivation layer 106 on the first and second conductive patterns 101 and 102 and the insulating pattern 105, gate electrodes 130 stacked on lower surfaces of the first and second conductive patterns 101 and 102 and the insulating pattern 105, interlayer insulating layers 120 alternately stacked with the gate electrodes 130 and forming a gate structure, first and second channel structures CH1 and CH2 disposed to penetrate the gate electrodes 130 and the interlayer insulating layers 120, and a cell bonding structure. The cell bonding structure may include a second bonding metal layer 198 and a second bonding insulating layer 199.

In some example embodiments, a substrate structure including the first and second conductive patterns 101 and 102 and an insulating pattern 105 surrounding side surfaces of the first and second conductive patterns 101 and 102 may be referred to as a "memory cell substrate."

Each of the first and second conductive patterns 101 and 102 may have a plate shape extending in the first direction (X-direction) and may be spaced apart from each other in the second direction (Y-direction). The first and second conductive patterns 101 and 102 may be disposed between the first isolation structure MS1 and the second isolation structure MS2.

The first and second conductive patterns 101 and 102 may include a conductive material. For example, the first and second conductive patterns 101 and 102 may include a semiconductor material, such as a group IV semiconductor, a group III-V compound semiconductor or a group II-VI compound semiconductor. For example, the group IV semiconductor may include silicon, germanium, or silicon-germanium. However, example embodiments are not limited thereto. The first and second conductive patterns 101 and 102 may further include impurities. The first and second conductive patterns 101 and 102 may be provided as a polycrystalline semiconductor layer, such as a polycrystalline silicon layer or an epitaxial layer. However, example embodiments are not limited thereto. The first conductive pattern 101 may be directly connected to the channel pattern 140 of each of the first channel structures CH1. The second conductive pattern 102 may be directly connected to the channel pattern 140 of each of the second channel structures CH2.

The gate electrodes 130 may be stacked and spaced apart from each other in the vertical direction (Z-direction) on the lower surface of the memory cell substrate and may form a mold structure (or a stack structure) together with the interlayer insulating layers 120. The gate electrodes 130 may include an upper select gate electrode 130L forming a ground select transistor, memory gate electrodes 130M forming a plurality of memory cells, and a lower select gate electrode 130U forming a string select transistor. The number of memory gate electrodes 130M forming the memory cells may be determined depending on capacity of the semiconductor device 100. The number of the upper select gate electrode 130L and the lower select gate electrode 130U may be one or more. In some example embodiments, a gate electrode including an erase transistor may be disposed between the memory gate electrodes 130M and the upper select gate electrode 130L and between the memory gate electrodes 130M and the lower select gate electrode 130U. In some example embodiments, a portion of the memory gate electrodes 130M may be a dummy gate electrode.

The gate electrodes 130 may include a conductive material, such as at least one metal material selected from a group consisting of tungsten (W), molybdenum (Mo), tantalum (Ta), ruthenium (Ru), niobium (Nb), osmium (Os), zirconium (Zr), iridium (Ir), rhenium (Re), and titanium (Ti), or a semiconductor material, such as polycrystalline silicon. However, example embodiments are not limited thereto.

The interlayer insulating layers 120 may be disposed between the gate electrodes 130. Similarly to the gate electrodes 130, the interlayer insulating layers 120 may be spaced apart from each other in a third direction (Z-direction) perpendicular to the lower surface of the memory cell substrate. The interlayer insulating layers 120 may include an insulating material, such as silicon oxide or silicon nitride. However, example embodiments are not limited thereto. In some example embodiments, a thickness of each of the interlayer insulating layers 120 may be varied.

The first and second isolation structures MS1 and MS2 may be disposed to penetrate the gate electrodes 130 and to extend in the first direction (X-direction). As illustrated in FIG. 3, the first and second isolation structures MS1 and MS2 may be disposed parallel to each other in the first direction (X-direction). The gate electrodes 130 isolated by the first and second isolation structures MS1 and MS2 may form a memory cell block (e.g., the first memory cell block BLK1). However, example embodiments of the memory cell block are not limited thereto. The first and second isolation structures MS1 and MS2 may penetrate the gate electrodes 130 stacked on a lower surface of the memory cell substrate and may be in contact with the insulating pattern 105. The first and second isolation structures MS1 and MS2 may include an insulating material, for example, silicon oxide, silicon nitride, or silicon oxynitride. However, example embodiments are not limited thereto.

The first channel structures CH1 may be disposed between the first isolation structure MS1 and the second isolation structure MS2, may penetrate the gate electrodes 130, may extend in the third direction (Z-direction), and may be connected to the first conductive pattern 101. The first channel structures CH1 may be channel structures disposed in the first page region (e.g., the first page region P1 in FIG. 3) of the first memory cell block (e.g., the first memory cell block BLK1 in FIG. 3).

The second channel structures CH2 may be disposed between the first isolation structure MS1 and the second isolation structure MS2, and may be spaced apart from the first channel structures CH1 in the second direction (Y-direction). The second channel structures CH2 may penetrate the gate electrodes 130, may extend in the third direction (Z-direction) and may be connected to the second conductive pattern 102. The second channel structures CH2 may be channel structures disposed in the second memory cell block (e.g., the second page region P2 in FIG. 3) of the second memory cell block BLK2 in FIG. 3.

Each of the first channel structures CH1 and the second channel structures CH2 may include channel structures CHS. In some example embodiments, each of the channel structures CHS may include connection patterns CB connecting first to fourth channel holes CHa-CHd to each other and the first to fourth channel holes CHa-CHd penetrating the gate electrodes 130 and the interlayer insulating layer 120 in the third direction (Z-direction). The first to fourth channel holes CHa-CHd may be disposed in a zigzag pattern in the second direction (Y-direction) on the X-Y plane. The first to fourth channel holes CHa-CHd may have a pillar shape, and may have an inclined side surface having a width decreasing toward the first conductive pattern 101 (or the second conductive pattern 102).

The channel structures CH may include data storage patterns 141, 142, and 143 disposed in the first to fourth channel holes CHa-CHd of the channel structures CHS included in the channel structures CH, a channel pattern 140 extending from each of the first to fourth channel holes CHa-CHd, and channel filling insulating layer 147. In some example embodiments, the data storage patterns 141, 142, and 143 may be disposed between the gate electrodes 130 and the channel pattern 140 in the first to fourth channel holes CHa-CHd. The channel pattern 140 and the channel filling insulating layer 147 may form a connection pattern CB of each of the channel structures CHS.

The channel pattern 140 may include channel portions 140a disposed in the first to fourth channel holes CHa-CHd, respectively, and channel connection portions 140b and 140c extending from the channel portions 140a and connecting the channel portions 140a to each other. The channel portions 140a may be surrounded by data storage patterns 141, 142, and 143 in the first to fourth channel holes CHa-CHd, respectively, and may be formed in an annular shape surrounding a channel filling insulating layer 147. According to some example embodiments, the channel portions 140a may have a columnar shape, such as a cylinder or a prism, without the channel filling insulating layer 147. The channel portions 140a may include a first channel portion (or, the first channel layer) disposed in a first channel hole CHa, a second channel portion (or, the second channel layer) disposed in a second channel hole CHb, a third channel portion (or, the third channel layer) disposed in a third channel hole CHc, and a fourth channel portion (or, the fourth channel layer) disposed in a fourth channel hole CHd.

The channel connection portions 140b and 140c may extend from the channel portions 140a and may be exposed from the first to fourth channel holes CHa-CHd, and may be in contact with the first and second conductive patterns 101 and 102 or the insulating pattern 105. In some example embodiments, the channel connection portions 140b and 140c of the first channel structures CH1 may be in contact with the first conductive pattern 101 or the insulating pattern 105, and the channel connection portions 140b and 140c of the second channel structures CH2 may be in contact with the second conductive pattern 102 or the insulating pattern 105. In some example embodiments, a portion of the channel connection portions 140b and 140c may be in contact with the first and second conductive patterns 101 and 102, and the other portion of the channel connection portions 140b and 140c may be in contact with the insulating pattern 105 with respect to the first and second channel structures CH1 and CH2.

The channel connection portions 140b and 140c may include a first channel connection portion connecting the first channel portion disposed in the first channel hole CHa to the second channel portion disposed in the second channel hole CHb, and a second channel connection portion connecting the third channel portion disposed in the third channel hole CHc to the fourth channel portion disposed in the fourth channel hole CHd. The first channel connection portion and the second channel connection portion may be formed integrally.

The channel connection portions 140b and 140c may include extension portions 140b extending from the channel portions 140a and a body portion 140c connecting the extension portions 140b to each other. Each of the extension portions 140b may extend from the first to fourth channel portions 140a in the first to fourth channel holes CHa-CHd and may have a columnar shape. The body portion 140c may extend from the extension portions 140b and may have a lower surface disposed on a level higher than a level of an upper surface of the gate electrodes 130. The extension portions 140b may have a shape of which a width decreases from a lower surface to an upper surface. Each of the extension portions 140b may be branched from the body portion 140c and may be connected to the first to fourth channel portions 140a in the first to fourth channel holes CHa-CHd. The channel pattern 140 may include a semiconductor material such as polycrystalline silicon or single crystal silicon.

The channel connection portions 140b and 140c extending from at least two of the channel holes among the first to fourth channel holes CHa-CHd may be in contact with the first and second conductive patterns 101 and 102 or the insulating pattern 105. In some example embodiments, the channel connection portions 140b and 140c extending from the second and third channel holes CHb and CHc may be in contact with the first and second conductive patterns 101 and 102, and the channel connection portions 140b and 140c extending from the first and fourth channel holes CHa and CHd may be in contact with the insulating pattern 105. The channel connection portions 140b and 140c extending from the second and third channel portions of the second and third channel holes CHb and CHc of the channel structure CHS included in the first channel structures CH1 may be in contact with the first conductive pattern 101, and the channel connection portions 140b and 140c extending from the first and fourth channel portions of the first and fourth channel holes CHa and CHd may be in contact with the insulating pattern 105. The channel connection portions 140b and 140c extending from the second and third channel portions of the second and third channel holes CHb and CHc of the channel structure CHS included in the second channel structures CH2 may be in contact with the second conductive pattern 102, and the channel connection portions 140b and 140c extending from the first and fourth channel portions of the first and fourth channel holes CHa and CHd may be in contact with the insulating pattern 105.

The channel filling insulating layer 147 may be surrounded by the channel pattern 140. The channel filling insulating layer 147 may include first insulating portions 147a surrounded by the channel portion 140a of the channel pattern 140 in the first to fourth channel holes Cha-CHd, and a second insulating connection portion 147b extending from the first insulating portions 147a, exposed from the first to fourth channel holes CHa-CHd and surrounded by the channel connection portion 140b and 140c. The channel filling insulating layer 147 may include an insulating material, for example, silicon oxide, silicon nitride, or silicon oxynitride.

Each of the first and second channel structures CH1 and CH2 may further include channel pads 149 disposed at a lower end of each of the first to fourth channel holes CHa-CHd. The channel pads 149 may include, for example, doped polycrystalline silicon. The channel pads 149 disposed at a lower end of each of the first to fourth channel holes CHa-CHd of the channel structures CHS included in the first channel structures CH1 may be connected to the first to fourth studs 171a-171d. In some example embodiments, the channel pad 149 disposed at a lower end of the first channel hole CHa of the first channel structures CH1 may be connected to the first stud 171a, channel pad 149 disposed at a lower end of the second channel hole CHb of the first channel structures CH1 may be connected to the second stud 171b, channel pad 149 disposed at a lower end of the third channel hole CHc of the first channel structures CH1 may be connected to the third stud 171c, and channel pad 149 disposed at a lower end of the fourth channel hole CHd of the first channel structures CH1 may be connected to the fourth stud 171d. The first channel hole CHa of the first channel structures CH1 may be connected to the first conductive interconnection BLa through the first stud 171a, the second channel hole CHb of the first channel structures CH1 may be connected to the third conductive interconnection BLc through the second stud 171b, the third channel hole CHc of the first channel structures CH1 may be connected to the second conductive interconnection BLb through the third stud 171c, and the fourth channel hole CHd of the first channel structures CH1 may be connected to the fourth conductive interconnection BLd through the fourth stud 171d.

In some example embodiments, the second channel hole CHb of the first channel structures CH1 and the second channel hole CHb of the second channel structures CH2 may be connected to the same bit line (e.g., bit line BL in FIG. 1). For example, the second stud 171b disposed in a lower portion of the channel pad 149 of the second channel hole CHb of the first channel structures CH1 and the second stud 172b disposed in a lower portion of the channel pad 149 of the second channel hole CHb of the second channel structures CH2 may be connected to the third conductive interconnection BLc in common. In some example embodiments, the fourth channel hole CHd of the first channel structures CH1 and the fourth channel hole CHd of the second channel structures CH2 may be connected to the same bit line (e.g., bit line BL in FIG. 1). For example, the fourth stud 171d disposed in a lower portion of the channel pad 149 of the fourth channel hole CHd of the first channel structures CH1 and the fourth stud 172d disposed in a lower portion of the channel pad 149 of the fourth channel hole CHd of the second channel structures CH2 may be connected to the fourth conductive interconnection BLd in common.

The data storage patterns 141, 142, and 143 may be disposed between the channel portions 140a of the channel pattern 140 and the gate electrodes 130. The data storage patterns 141, 142, and 143 may include a blocking layer 141, a data storage layer 142, and a tunneling layer 143. The blocking layer 141, the data storage layer 142, and the tunneling layer 143 may be disposed in order on the gate electrodes 130. The data storage patterns 141, 142, and 143 may include a first data storage pattern disposed in the first channel hole CHa, a second data storage pattern disposed in the second channel hole CHb, a third data storage pattern disposed in the third channel hole CHc, and a fourth data storage pattern disposed in the fourth channel hole CHd.

Data storage patterns 141, 142, and 143 may be disposed only in the first to fourth channel holes CHa-CHd, and may not be exposed by the first to fourth channel holes CHa-CHd.

The tunneling layer 143 may be disposed between the data storage layer 142 and the channel portion 140a of the channel pattern 140, and may tunnel charges into the data storage layer 142, and may include, for example, silicon oxide (SiO2), silicon nitride (Si₃N₄), silicon oxynitride (SiON), or a combination thereof. However, example embodiments are not limited thereto. The data storage layer 142 may be disposed between the blocking layer 141 and the tunneling layer 143, and may be a charge trap layer or a floating gate conductive layer. The blocking layer 141 may be disposed between the gate electrodes 130 and the data storage layer 142, and may include silicon oxide (SiO₂), silicon nitride (Si₃N₄), silicon oxynitride (SiON), a high-κ dielectric material, or a combination thereof. However, example embodiments are not limited thereto.

The cell region insulating layer 190 may be disposed on a lower surface of the gate electrodes 130, and may be in contact with cell bonding structures 198 and 199. The contact plugs 174 and the interconnection lines 172 may be included in the cell region insulating layer 190. The contact plugs 174 may have a cylindrical shape, and the interconnection lines 172 may have a line shape. The contact plug 174 and the interconnection lines 172 may include a conductive material, for example, tungsten (W), copper (Cu), aluminum (Al), and each component may further include a diffusion barrier. However, example embodiments are not limited thereto. The contact plug 174 and the interconnection lines 172 may be referred to as a second interconnection structure.

The second bonding metal layers 198 may be connected to the first bonding metal layers 298 of the peripheral circuit structure PERI. In some example embodiments, a portion of the second bonding metal layers 198 may not be connected to the cell interconnection structure, and may be disposed only for bonding.

The second bonding metal layer 198 may include a conductive material, for example, copper (Cu). The second bonding insulating layer 199 may be disposed around the second bonding metal layers 198. The second bonding insulating layer 199 may also function as a diffusion barrier for the second bonding metal layers 198 and may include, for example, at least one of SiN, SiON, SiCN, SiOC, SiOCN, or SiO. However, example embodiments are not limited thereto.

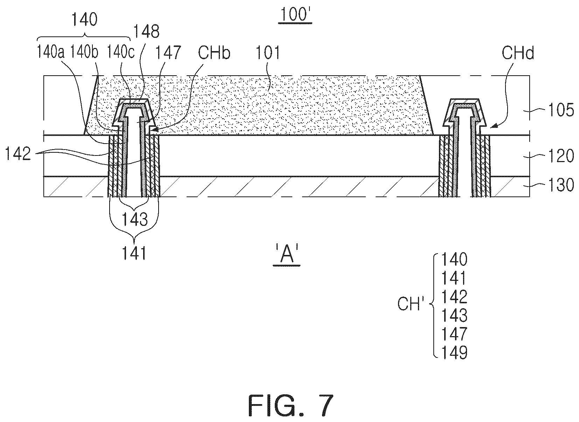

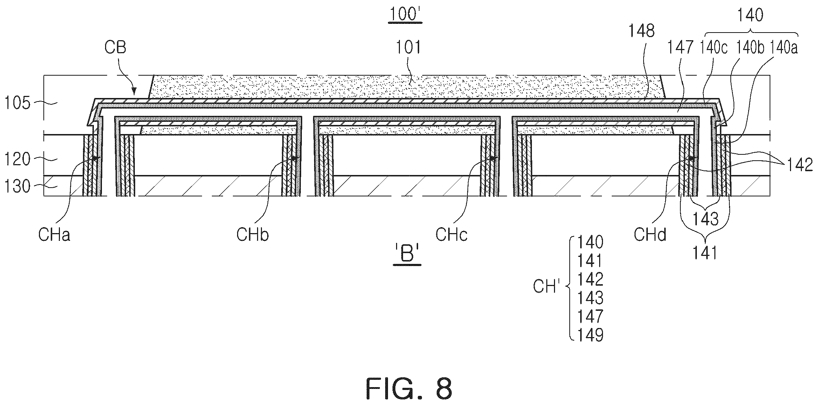

FIG. 7 is an enlarged diagram illustrating region A according to some example embodiments. FIG. 8 is an enlarged diagram illustrating region B in FIG. 6A according to some example embodiments.

Referring to FIGS. 7 and 8, the other components of the semiconductor device 100' other than the channel structures CH' may be the same as or may correspond to the components illustrated in FIGS. 5A to 6B.

Each of the channel structures CH' may include data storage patterns 141, 142, and 143 disposed in first to fourth channel holes CHa-CHd of the channel structures CHS included in the channel structures CH', channel patterns 140 extending from the first to fourth channel holes CHa-CHd, channel filling insulating layers 147, and conductive liners 148. In some example embodiments, the data storage patterns 141, 142, and 143 may be disposed between gate electrodes 130 and the channel pattern 140 in the first to fourth channel holes CHa-CHd. The channel pattern 140, the channel filling insulating layer 147, and the conductive liner 148 may be included in the connection pattern CB of each of the channel structures CHS.

The conductive liner 148 may cover the channel pattern 140 exposed from the first to fourth channel holes CHa-CHd. In some example embodiments, the conductive liner 148 may cover only the channel connection portions 140b and 140c of the channel pattern 140. The conductive liner 148 may be disposed depending on a surface profile of the channel connection portions 140b and 140c of the channel pattern 140. In some example embodiments, the conductive liner 148 may include a semiconductor material such as polycrystalline silicon or single crystal silicon. However, example embodiments are not limited thereto. The conductive liner 148 may include an impurity region including first impurities, and the first impurities may be N-type impurities and may include at least one of phosphorus (P), arsenic (As), or antimony (Sb). The conductive liner 148 may be formed by an atomic layer deposition (ALD) process or an area selective deposition (ASD) process. However, example embodiments are not limited thereto.

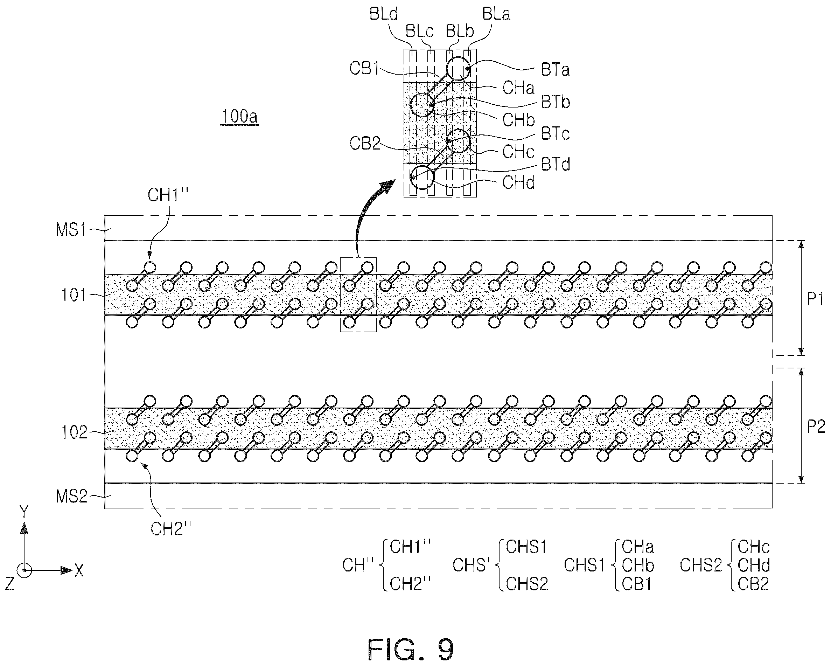

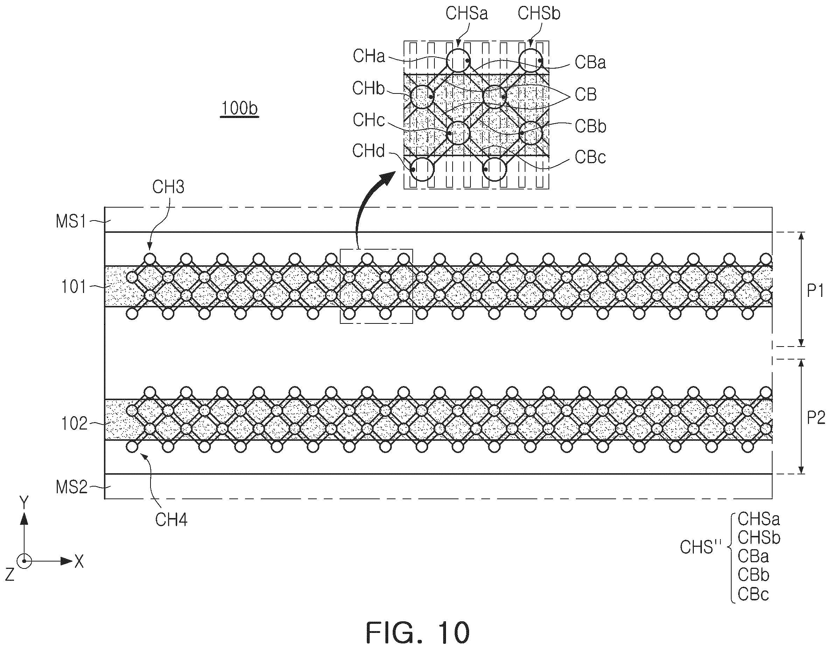

FIGS. 9 and 10 are enlarged diagrams illustrating a cell array region of the semiconductor device illustrated in FIG. 3 according to some example embodiments.

FIGS. 9 and 10 illustrate plan diagrams illustrating first and second page regions P1 and P2 in one of memory cell blocks BLK1 and BLK2 of a plurality of memory cell blocks of cell array region R1 of semiconductor devices 100a and 100b.

Referring to FIG. 9, a plurality of channel structures CH" may be disposed in each of the first and second page regions P1 and P2 of the semiconductor device 100a. The first channel structures CH1" may be disposed in the first page region P1, and the second channel structures CH2" may be disposed in the second page region P2. Each of the first channel structures CH1" and the second channel structures CH2" may include a plurality of channel structures CHS' spaced apart from each other in the first direction (X-direction). Each of the plurality of channel structures CHS' may include first channel structures CHS1 and second channel structures CHS2 spaced apart from the first channel structures CHS 1 in the second direction (Y-direction).

Each of the first channel structures CHS1 may include a first channel hole CHa, a second channel hole CHb, and a first connection pattern CB1 connecting the first channel hole CHa to the second channel hole CHb. Each of the first channel structures CHS1 may be spaced apart from each other in the first direction (X-direction). Each of the first and second channel holes CHa and CHb may extend in the third direction (Z-direction) and may penetrate the mold structure. The first channel hole CHa and the second channel hole CHb may be arranged alternately in a direction between the first direction (X-direction) and the second direction (Y-direction) on the X-Y plane. The first connection pattern CB1 may be configured to extend from each of the first channel hole CHa and the second channel hole CHb and to connect the first and second channel holes CHa and CHb to each other.

Each of the second channel structures CHS2 may include a third channel hole CHc, a fourth channel hole CHd, and a second connection pattern CB2 connecting the third channel hole CHc to the fourth channel hole CHd. Each of the second channel structures CHS2 may be spaced apart from each other in the first direction (X-direction). The third and fourth channel holes CHc and CHd may extend in the third direction (Z-direction) and may penetrate the mold structure. The third channel hole CHc and the fourth channel hole CHd may be alternately arranged in a direction between the first direction (X-direction) and the second direction (Y-direction) on the X-Y plane. The second connection pattern CB2 may be configured to extend from each of the third channel hole CHc and the fourth channel hole CHd and to connect the third and fourth channel holes CHc and CHd to each other.

The first and second channel holes CHa and CHb of each of the first channel structures CHS1 and third and fourth channel holes CHc and CHd of each of the second channel structures CHS2 may be arranged in order in a zigzag pattern in the second direction (Y-direction). The first connection pattern CB1 of each of the first channel structures CHS1 and the second connection pattern CB2 of each of the second channel structures CHS2 may be spaced apart from each other in the second direction (Y-direction).

The semiconductor device 100a may be disposed in a cell array region (e.g., cell array region R1) and may further include first, second, third, and fourth conductive interconnections BLa, BLb, BLc, and BLd connected to first, second, third, and fourth channel holes CHa, CHb, CHc, and CHd, respectively. The first, second, third, and fourth conductive interconnections BLa, BLb, BLc, and BLd may extend in the second direction (Y-direction) and may be spaced apart from each other in the first direction (X-direction). The first conductive interconnection BLa may overlap the first channel hole CHa of the first channel structures CHS 1 in the vertical direction (Z-direction) and may be connected to the first channel hole CHa through the first contact pad BTa. The second conductive interconnection BLb may overlap the third channel hole CHc of the second channel structures CHS2 in the vertical direction (Z-direction) and may be connected to the third channel hole CHc through the third contact pad BTc. The third conductive interconnection BLc may overlap the second channel hole CHb of the first channel structures CHS1 in the vertical direction (Z-direction) and may be connected to the second channel hole CHb through the second contact pad BTb. The fourth conductive interconnection BLd may overlap the fourth channel hole CHd of the second channel structures CHS2 in the vertical direction (Z-direction) and may be connected to the fourth channel hole CHd through the fourth contact pad BTd. The first, second, third, and fourth conductive interconnections BLa, BLb, BLc, and BLd may be connected to the bit lines BL in FIG. 2.

The semiconductor device 100a may further include a first conductive pattern 101 disposed on a first page region P1 and a second conductive pattern 102 disposed on a second page region P2. In some example embodiments, the first conductive pattern 101 and the second conductive pattern 102 may extend in the first direction (X-direction) and may be spaced apart from each other in the second direction (Y-direction). The first conductive pattern 101 may overlap at least a portion of first channel structures CH1" on the first channel structures CH1". The second conductive pattern 102 may overlap at least a portion of second channel structures CH2" on the second channel structures CH2. In some example embodiments, the first conductive pattern 101 may overlap the second channel hole CHb of the first channel structure CHS1 of the first channel structures CH1" and the third channel hole CHc of the second channel structure CHS2. The first conductive pattern 101 may not overlap the first channel hole CHa of the first channel structure CHS1 of the first channel structures CH1" and the fourth channel hole CHd of the second channel structure CHS2. The first conductive pattern 101 may be in contact with a portion of the first connection pattern CB1 of the first channel structure CHS1 of the first channel structure CH1" and a portion of the second connection pattern CB2 of the second channel structure CHS2. The second conductive pattern 102 may overlap the second channel hole CHb of the first channel structure CHS1 of the second channel structures CH2 and the third channel hole CHc of the second channel structure CHS2. The second conductive pattern 102 may not overlap the first channel hole CHa of the first channel structure CHS1 of the first channel structures CH1" and the fourth channel hole CHd of the second channel structure CHS2. The second conductive pattern 102 may be in contact with a portion of the first connection pattern CB1 of the first channel structure CHS1 of the second channel structure CH2" and a portion of the second connection pattern CB2 of the second channel structure CHS2. The first and second conductive patterns 101 and 102 may not overlap the first channel hole CHa and the fourth channel hole CHd.

Referring to FIG. 10, the third channel structure CH3 may be disposed in the first page region P1 of the semiconductor device 100b, and the fourth channel structure CH4 may be disposed in the second page region P2.

Each of the third channel structure CH3 and the fourth channel structure CH4 may include the channel structure CHS". The channel structure CHS" may include a plurality of channel structures CHSa and CHSb and a plurality of connection patterns CBa, CBb, and CBc connecting the plurality of channel structures CHSa and CHSb to each other. The channel structure CHS" may have a mesh pattern. Each of the plurality of channel structures CHSa and CHSb may correspond to the channel structures CHS in FIG. 4. That is, the plurality of channel structures CHSa and CHSb may include a connection pattern CB connecting the first to fourth channel holes CHa-CHd to the first to fourth channel holes CHa-CHd. The plurality of connection patterns CBa, CBb, and CBc may include a 1-1 connection pattern CBa connecting the first channel hole CHa of the channel structure CHSa to the second channel hole CHb of the channel structure CHSb, a 1-2 connection pattern CBb connecting the third channel hole CHc of the channel structure CHSa to the second channel hole CHb of the channel structure CHSb, and a 1-3 connection pattern CBc connecting the third channel hole CHc of the channel structure CHSa to the fourth channel hole CHd of the channel structure CHSb.

The semiconductor device 100b may further include a first conductive pattern 101 disposed on the first page region P1 and a second conductive pattern 102 disposed on the second page region P2. In some example embodiments, the first conductive pattern 101 and the second conductive pattern 102 may extend in the first direction (X-direction) and may be spaced apart from each other in the second direction (Y-direction). The first conductive pattern 101 may overlap at least a portion of the third channel structure CH3 on the third channel structure CH3. The second conductive pattern 102 may overlap at least a portion of the fourth channel structure CH4 on the fourth channel structure CH4. In some example embodiments, the first conductive pattern 101 may overlap the second and third channel holes CHb and CHc of the channel structure CHS" of the third channel structure CH3, and may not overlap the first and fourth channel holes CHa and CHd of the channel structure CHS" of the third channel structure CH3. The second conductive pattern 102 may overlap the second and third channel holes CHb and CHc of the "channel structure CHS" of the fourth channel structure CH4, and may not overlap the first and fourth channel holes CHa and CHd of the "channel structure CHS" of the fourth channel structure CH4.

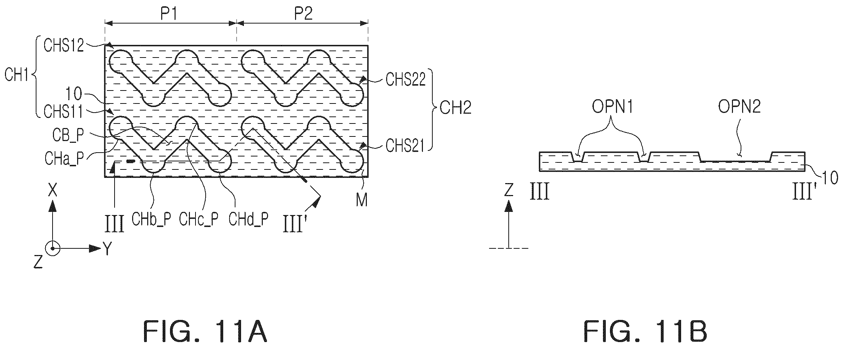

FIGS. 11A to 21B are diagrams illustrating a method of manufacturing a semiconductor device according to some example embodiments.

Referring to FIGS. 11A to 21B, FIGS. 11A, 12A, 13A, 14A, 15A, 16A, 17A, 18A, 19A, 20A, and 21A may represent an X-Y plane view of a cell array region (e.g., the cell array region R1 in FIG. 3), and FIGS. 11B, 12B, 13B, 14B, 15B, 16B, 17B, 18B, 19B, 20B, and 21B may represent a cross-section taken along line III-III' of the cell array region.

Referring to FIGS. 11A and 11B, on the X-Y plane of the preliminary semiconductor substrate 10, first to fourth preliminary channel holes CHa_P-CHd_P may be formed alternately in the second direction (Y-direction), and preliminary connection patterns CB_P connecting the first to fourth preliminary channel holes CHa_P-CHd_P to each other may be formed.

The first to fourth preliminary channel holes CHa_P-CHd_P and the preliminary connection pattern CB_P may be formed in regions corresponding to positions of the channel structures CHS11 and CHS12 of the first channel structures CH1 and the channel structures CHS21 and CHS22 of the second channel structures CH2 to be formed by a subsequent process, respectively. Since the channel structures CHS11 and CHS12 of the first channel structures CH1 and the channel structures CHS21 and CHS22 of the second channel structures CH2 to be formed by the subsequent process are spaced apart from each other in the second direction (Y-direction), the positions at which the first to fourth preliminary channel holes CHa_P-CHd_P and the preliminary connection pattern CB_P are formed may be determined accordingly. Each of the channel structures CHS11 and CHS12 of the first channel structures CH1 and the channel structures CHS21 and CHS22 of the second channel structures CH2 may correspond to the channel structure CHS in FIG. 4.

The first to fourth preliminary channel holes CHa_P-CHd_P and the preliminary connection pattern CB_P may be formed by etching a portion of an upper surface of the preliminary semiconductor substrate 10 through an etch-back process. The first to fourth preliminary channel holes CHa_P-CHd_P and the preliminary connection pattern CB_P may be formed by a wet or dry etching process.

The first openings OPN1 may be formed on the X-Y plane of the preliminary semiconductor substrate 10 to correspond to the first to fourth preliminary channel holes CHa_P-CHd_P, and the second opening OPN2 connecting the first openings OPN1 may be formed on the X-Y plane of the preliminary semiconductor substrate 10 to correspond to the preliminary connection pattern CB_P.

The second opening OPN2 may extend toward the first openings OPN1 in which the first to fourth preliminary channel holes CHa_P-CHd_P are formed between the first to fourth preliminary channel holes CHa_P-CHd_P.

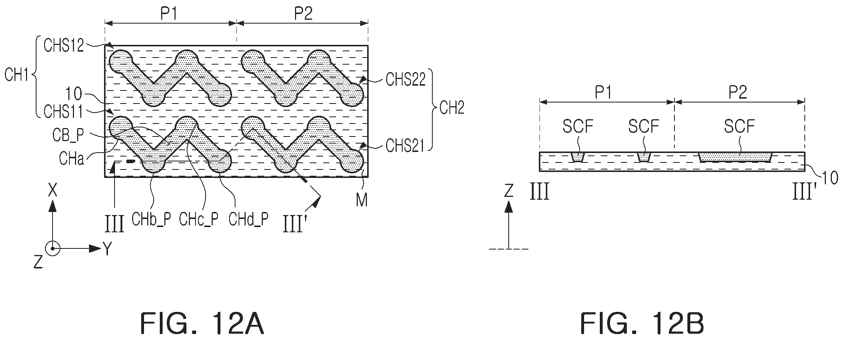

Referring to FIGS. 12A and 12B, the first to fourth preliminary channel holes CHa_P-CHd_P and the preliminary connection pattern CB_P may be filled with a sacrificial material SCF. The sacrificial material SCF may include polycrystalline silicon.

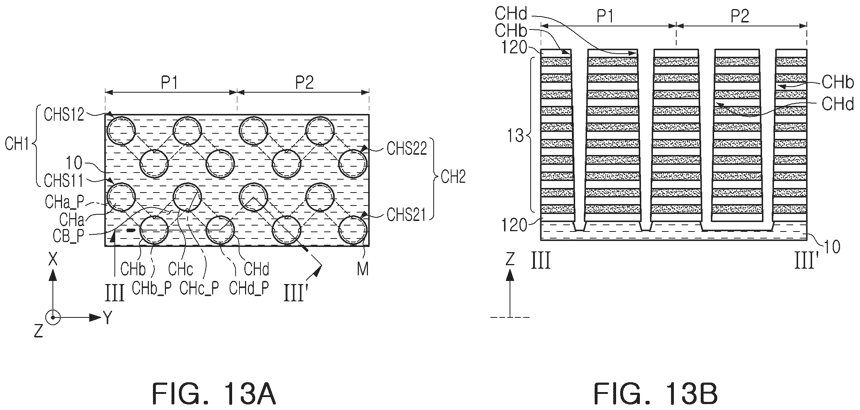

Referring to FIGS. 13A and 13B, a plurality of mold sacrificial films 13 and a plurality of interlayer insulating layers 120 may be alternately formed on the preliminary semiconductor substrate 10, and first to fourth channel holes CHa-CHd connected to the first to fourth preliminary channel holes CHa_P-CHd_P may be formed by penetrating the plurality of mold sacrificial films 13 and the plurality of interlayer insulating layers 120.

The plurality of mold sacrificial films 13 may include a material having etch selectivity with respect to the plurality of interlayer insulating layers 120. In some example embodiments, the plurality of mold sacrificial films 13 may include silicon nitride, and the plurality of interlayer insulating layers 120 may include silicon oxide. By forming the first to fourth channel holes CHa-CHd penetrating the plurality of mold sacrificial films 13 and the plurality of interlayer insulating layers 120, the first to fourth preliminary channel holes CHa_P-CHd_P on the preliminary semiconductor substrate 10 may be exposed.

As for forming first to fourth channel holes CHa-CHd, by forming a hard mask pattern on a plurality of mold sacrificial films 13 and a plurality of interlayer insulating layers 120 and anisotropically etching the plurality of mold sacrificial films 13 and the plurality of interlayer insulating layers 120 using the hard mask pattern as an etching mask, first to fourth channel holes CHa-CHd extending in the third direction (Z-direction) may be formed.

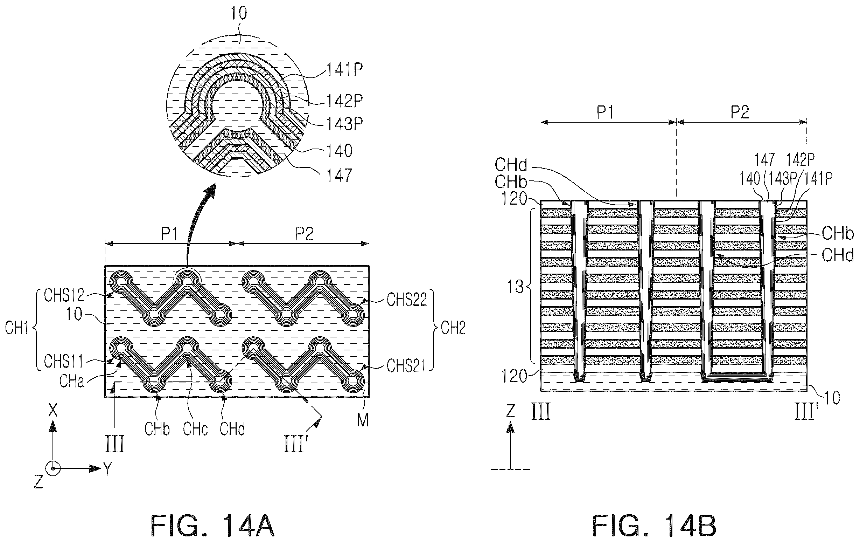

Referring to FIGS. 14A and 14B, preliminary data storage patterns 141P, 142P, and 143P, channel pattern 140 and channel filling insulating layer 147 may be formed in order in the first to fourth channel holes CHa-CHd, the first to fourth preliminary channel holes CHa_P-CHd_P and the preliminary connection pattern CB_P. As for the preliminary data storage patterns 141P, 142P, and 143P, the channel pattern 140, and the channel filling insulating layer 147, the blocking layer 141P, the data storage layer 142_P, the tunneling layer 143_P, the channel pattern 140, and the channel filling insulating layer 147 may be formed with a uniform or substantially uniform thickness on bottom surface of the first to fourth preliminary channel holes CHa_P-CHd_P, the preliminary connection pattern CB_P and sidewalls of the first to fourth channel holes CHa-CHd.

The data storage layer 142_P may include silicon nitride or metal oxide, which may trap charges, and the blocking layer 141P and the tunneling layer 143_P may be formed of silicon oxide or metal oxide. Here, the metal oxide may have a higher dielectric constant as compared to silicon nitride.

The preliminary data storage patterns 141P, 142P, and 143P, the channel pattern 140 and the channel filling insulating layer 147 may be formed by a chemical vapor deposition (CVD) or an atomic layer deposition (ALD) process. The enlarged diagram illustrated in FIG. 14A illustrates a cross-sectional diagram illustrating a region in which the preliminary connection pattern CB_P connecting the first to fourth preliminary channel holes CHa_P-CHd_P to each other in FIG. 11A is disposed.

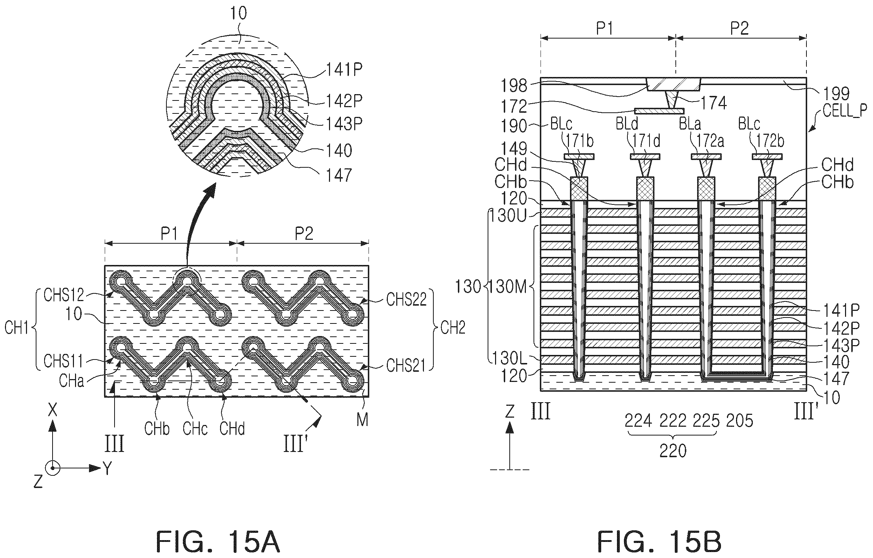

Referring to FIGS. 15A and 15B, a process of forming the channel pads 149 on the first to fourth channel holes CHa-CHd, respectively, a process of removing the plurality of mold sacrificial films 13 and the forming gate electrodes 130, and a process of forming contact plugs 174, interconnection lines 172, a cell region insulating layer 190, a second bonding metal layer 198, and a second bonding insulating layer 199 may be included.

The preliminary data storage patterns 141P, 142P, and 143P, the channel pattern 140 and the channel filling insulating layer 147 may be formed in order, and channel pads 149 may be formed on the first to fourth channel holes CHa-CHd. The channel pads 149 may be formed by forming a mask pattern on the first to fourth channel holes CHa-CHd, and forming the channel pads 149 using the mask pattern. The channel pads 149 may include a conductive material, for example, polycrystalline silicon. After the channel pads 149 is formed, a process of forming studs 171b, 171d, 172a, and 172b on the channel pads 149, and forming conductive interconnections BLa, BLc, and BLd connected to the studs 171b, 171d, 172a, and 172b may be further included. In some example embodiments, the second stud 171b may be formed on the channel pad 149 of the second channel hole CHb of the first channel structure CH1, and the fourth stud 171d may be formed on the channel pad 149 of the fourth channel hole CHd of the first channel structure CH1. A second stud 172a may be formed on the channel pad 149 of the first channel hole CHa of the second channel structure CH2, and a second stud 172b may be formed on the channel pad 149 of the second channel hole CHb of the second channel structure CH2.

A third conductive interconnection BLc may be formed on the second stud 171b of the first channel structure CH1 and the second stud 172b of the second channel structure CH2, a fourth conductive interconnection BLd may be formed on the fourth stud 171d of the first channel structure CH1, and a first conductive interconnection BLa may be formed on the first stud 172a of the second channel structure CH2.

A plurality of mold sacrificial films 13 may be removed and a conductive material may be deposited on the removed region, thereby forming gate electrodes 130. The conductive material may include metal, polycrystalline silicon, or a metal silicide material. However, example embodiments are not limited thereto.

The contact plugs 174 and the interconnection lines 172 may be formed in the cell region insulating layer 190.

A second bonding metal layer 198, which is a cell bonding structure, may be formed on the cell region insulating layer 190, and a second bonding insulating layer 199 surrounding the second bonding metal layer 198 may be formed. By forming the cell bonding structures 198 and 199 on the cell region insulating layer 190, a preliminary memory cell structure CELL_P may be formed.

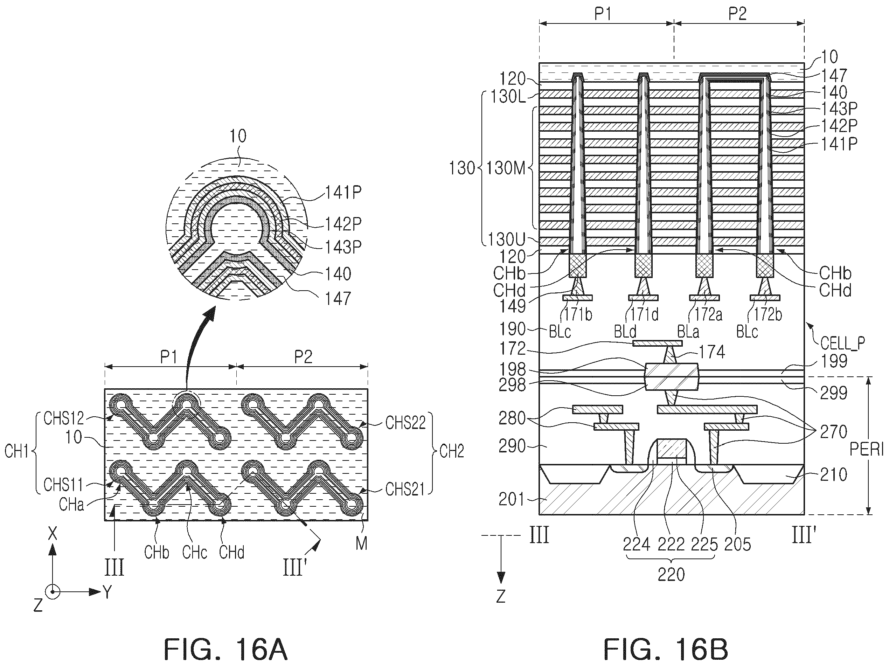

Referring to FIGS. 16A and 16B, the preliminary memory cell structure CELL_P may be disposed upside down and may be in contact with the peripheral circuit structure PERI. The peripheral circuit structure PERI may be formed before the preliminary memory cell structure CELL_P is formed. The peripheral circuit structure PERI may be formed prior to the process of manufacturing the memory cell structure CELL, or may be after the process of manufacturing the preliminary memory cell structure CELL_P.

By forming a substrate 201, circuit devices 220 on the substrate 201, circuit contact plugs 270, circuit interconnection lines 280, peripheral region insulating layer 290, and peripheral bonding structure, peripheral circuit structure PERI may be manufactured.

The preliminary memory cell structure CELL_P and the peripheral circuit structure PERI may be connected to each other by bonding by applying pressure to the first bonding insulating layer 299, the second bonding insulating layers 199, the first bonding metal layers 298, and the second bonding metal layers 198.

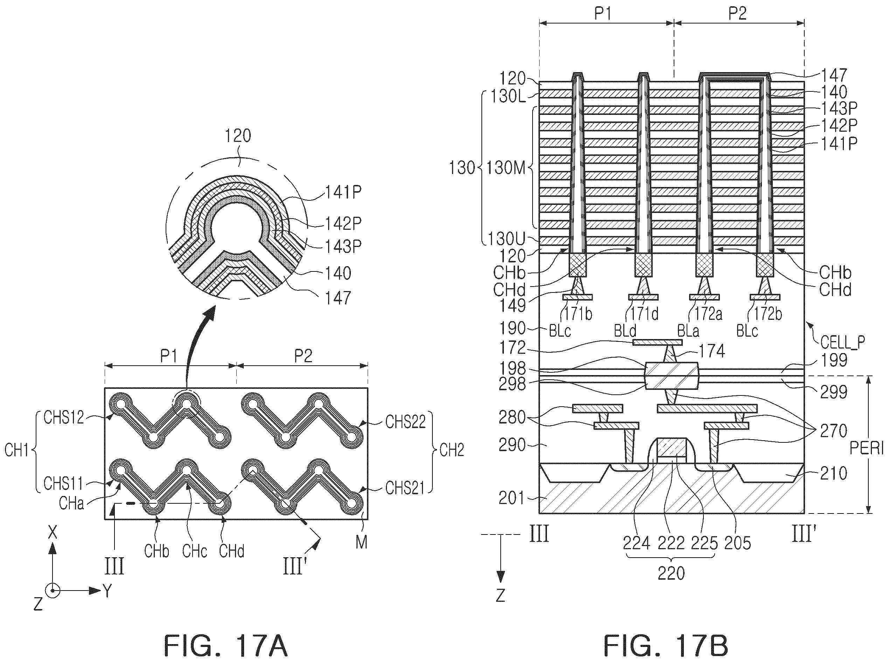

Referring to FIGS. 17A and 17B, the preliminary semiconductor substrate 10 may be removed. By removing the preliminary semiconductor substrate 10, the preliminary data storage patterns 141P, 142P, and 143P exposed from the first to fourth channel holes CHa-CHd may be exposed to an external entity. In some example embodiments, the preliminary data storage pattern 141P, 142P, and 143P filling the first to fourth preliminary channel holes (e.g., the first to fourth preliminary channel holes CHa_P-CHd_P in FIG. 13) and the preliminary connection pattern CB_P (e.g., preliminary connection pattern CB_P in FIG. 13) on one surface of the preliminary semiconductor substrate 10 and surrounding the channel pattern 140 may be exposed. Due to the difference in etching rates between a material included in the preliminary semiconductor substrate 10 and a material of the preliminary data storage patterns 141P, 142P, and 143P, the preliminary semiconductor substrate 10 in contact with the blocking layer 141P may be removed by a wet etching process.

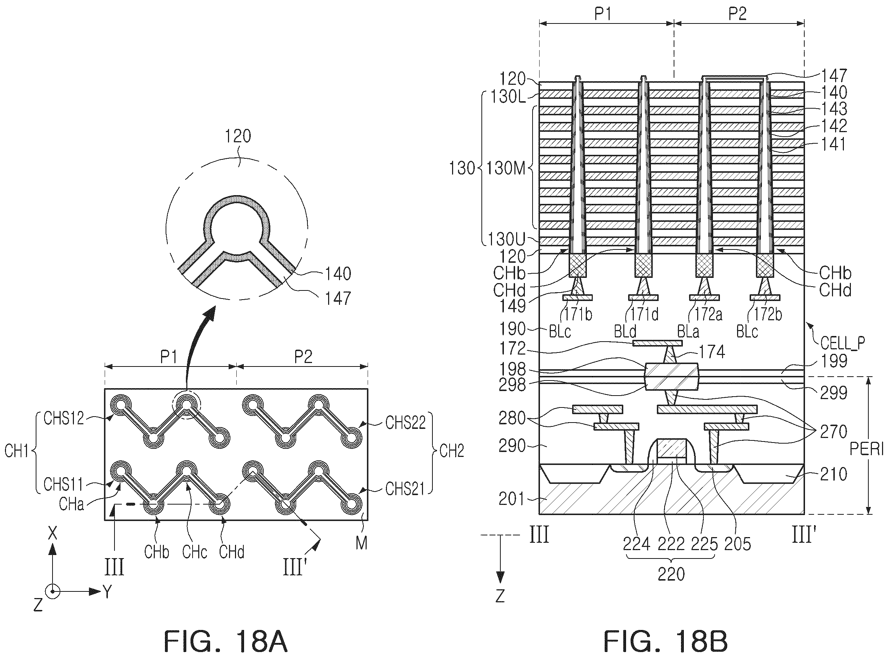

Referring to FIGS. 18A and 18B, the preliminary data storage patterns 141P, 142P, and 143P exposed from the first to fourth channel holes CHa-CHd may be removed. The data storage patterns 141, 142, and 143 disposed only in the first to fourth channel holes CHa-CHd may be formed. As the preliminary data storage patterns 141P, 142P, and 143P exposed from the first to fourth channel holes CHa-CHd are removed, the channel pattern 140 extending from the first to fourth channel holes CHa-CHd may be exposed.

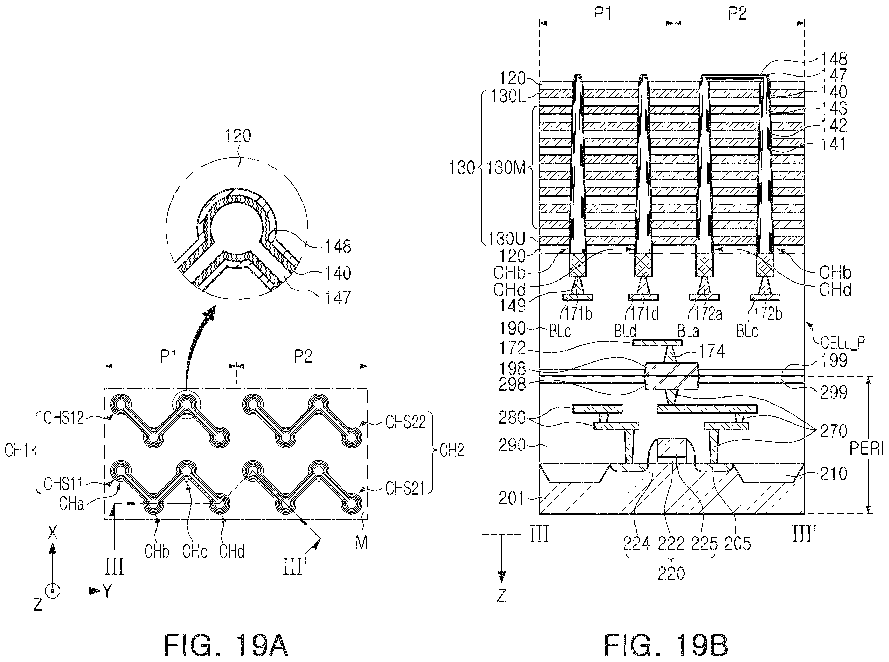

Referring to FIGS. 19A and 19B, a conductive liner 148 covering the channel pattern 140 exposed from the first to fourth channel holes CHa-CHd may be formed. The conductive liner 148 may be uniformly formed along a surface profile of the channel pattern 140 exposed from the first to fourth channel holes CHa-CHd. The conductive liner 148 may cover the extension portion (e.g., the extension portion of the channel connection portions 140b in FIG. 5B) and the body portion (e.g., the body portion of the channel connection portions 140c in FIG. 5B) of the channel pattern 140. The conductive liner 148 may include a semiconductor material such as polycrystalline silicon or single crystal silicon. However, example embodiments are not limited thereto. The conductive liner 148 may include an impurity region including first impurities, and the first impurities may include at least one of phosphorus (P), arsenic (As), or antimony (Sb) as N-type impurities. However, example embodiments are not limited thereto. The conductive liner 148 may be formed by an area selective deposition (ASD) process. In some example embodiments, the process of forming the conductive liner 148 may not be performed.

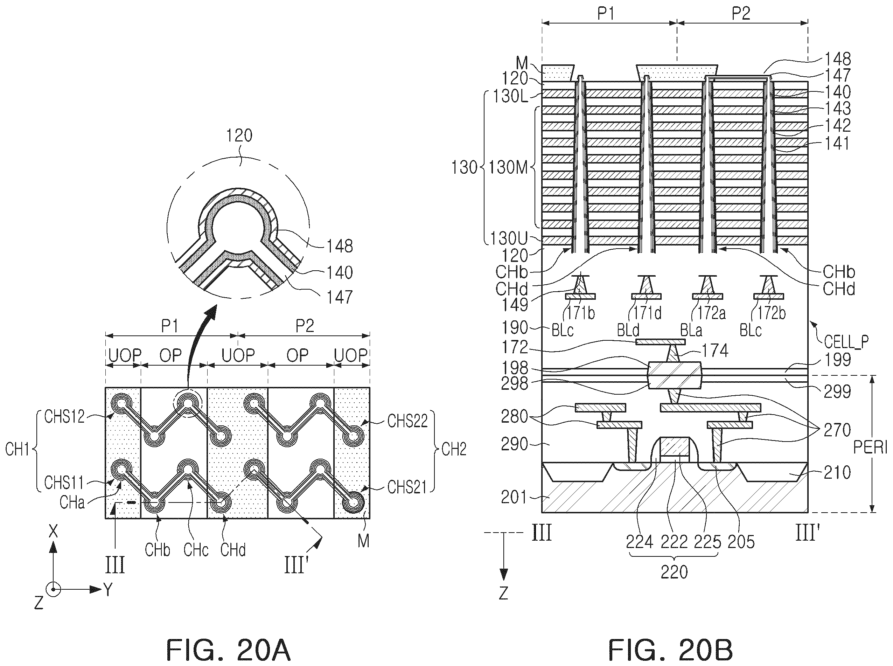

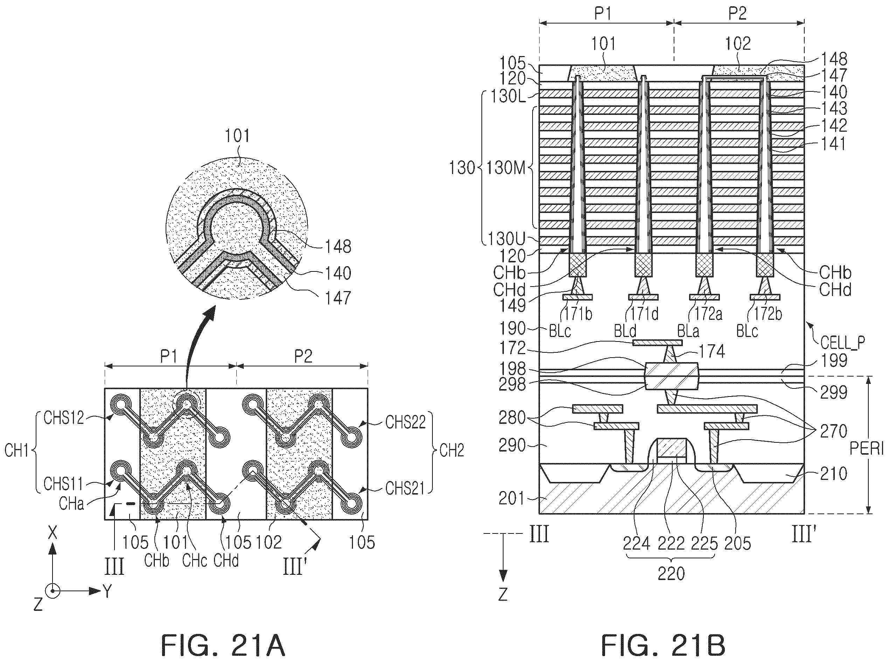

Referring to FIGS. 20A and 20B, mask patterns M having an open portion OP exposing the second and third channel holes CHb and CHc on the first to fourth channel holes CHa-CHd and a non-open portion UOP covering the first and fourth channel holes CHa and CHd may be formed with respect to the first and second channel structures CH1 and CH2, respectively. The mask patterns M may define regions in which the first and second conductive patterns (e.g., the first and second conductive patterns 101 and 102 in FIG. 21) are disposed. The mask patterns M may include amorphous carbon or polysilicon. The mask patterns M extending in the first direction (X-direction) may be formed with respect to the first channel structure CH1 formed in the first page region P1 and the second channel structure CH2 formed in the second page region P2. To form the mask patterns M, the process of forming a photoresist film (not illustrated), a photolithography process and an etching process may be performed.

Referring to FIGS. 21A and 21B, first and second conductive patterns 101 and 102 may be formed on the open portion OP of the mask patterns M exposing the second and third channel holes CHb and CHc of the first and second channel structures CH1 and CH2, respectively. By forming the first and second conductive patterns 101 and 102 through the mask pattern M, the first conductive pattern 101 may be in contact with the conductive liner 148 exposed from the second and third channel holes CHb and CHc of the first channel structure CH1, and the second conductive pattern 102 may be in contact with the conductive liner 148 exposed from the second and third channel holes CHb and CHc of the second channel structure CH2. Accordingly, the first conductive pattern 101 may be self-aligned with respect to the first channel structures CH1, and the second conductive pattern 102 may be self-aligned with respect to the second channel structures CH2. The first conductive pattern 101 may overlap at least two or more adjacent channel holes CHa-CHd among the first to fourth channel holes CHa-CHd of the first channel structure CH1 in the third direction (Z-direction), which is a vertical direction, and similarly, the second conductive pattern 102 may overlap at least two or more adjacent channel holes CHa-CHd among the first to fourth channel holes CHa-CHd of the second channel structure CH2 in the third direction (Z-direction), which is a vertical direction.

The mask pattern M may be removed, and an insulating pattern 105 may be formed between the first and second conductive patterns 101 and 102. The insulating pattern 105 may overlap the first and fourth channel holes CHa and CHd. Thereafter, by forming a passivation layer 106 on the first and second conductive patterns 101 and 102 and the insulating pattern 105, a semiconductor device 100' may be formed. In some example embodiments, when the process of forming the conductive liner 148 is not performed, the first conductive pattern 101 may be in contact with the channel pattern 140 exposed from the second and third channel holes CHb and CHc of the first channel structure CH1, and the second conductive pattern 102 may be in contact with the channel pattern 140 exposed from the second and third channel holes CHb and CHc of the second channel structure CH2. In this case, by forming a passivation layer 106 on the first and second conductive patterns 101 and 102 and the insulating pattern 105 after the process of forming the first and second conductive patterns 101 and 102 and the insulating pattern 105, the semiconductor device 100 may be formed.

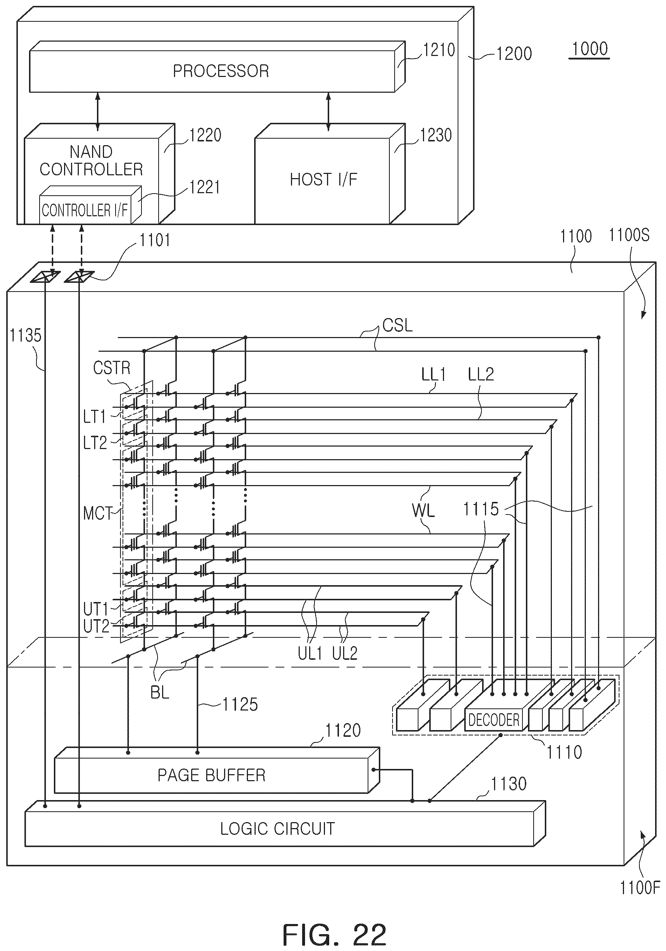

FIG. 22 is a diagram illustrating a data storage system including a semiconductor device according to some example embodiments.

Referring to FIG. 22, a data storage system 1000 may include a semiconductor device 1100 and a controller 1200 electrically connected to the semiconductor device 1100. The data storage system 1000 may be implemented as a storage device including one or a plurality of semiconductor devices 1100 or an electronic device including a storage device. For example, the data storage system 1000 may be implemented as a solid state drive device (SSD) including one or a plurality of semiconductor devices 1100, a universal serial bus (USB), a computing system, a medical device, or a communication device.

The semiconductor device 1100 may be implemented as a non-volatile memory device, such as, for example, the NAND flash memory device described in the aforementioned example embodiment with reference to FIGS. 1 to 2. The semiconductor device 1100 may include a first structure 1100F and a second structure 1100S on the first structure 1100F. In some example embodiments, the first structure 1100F may be disposed on the side of the second structure 1100S. The first structure 1100F may be implemented as a peripheral circuit structure including a decoder circuit 1110, a page buffer 1120, and a logic circuit 1130. The second structure 1100S may be implemented as a memory cell structure including a bit line BL, a common source line CSL, word lines WL, first and second gate upper lines UL1 and UL2, first and second gate lower lines LL1 and LL2 and memory cell strings CSTR disposed between the bit line BL and the common source line CSL.

In the second structure 1100S, each of the memory cell strings CSTR may include lower transistors LT1 and LT2 adjacent to the common source line CSL, upper transistors UT1 and UT2 adjacent to the bit line BL, and a plurality of memory cell transistors MCT disposed between the lower transistors LT1 and LT2 and the upper transistors UT1 and UT2. The number of lower transistors LT1 and LT2 and the number of upper transistors UT1 and UT2 may be varied in some example embodiments.

In some example embodiments, the upper transistors UT1 and UT2 may include a string select transistor, and the lower transistors LT1 and LT2 may include a ground select transistor. The gate lower lines LL1 and LL2 may be configured as gate electrodes of the lower transistors LT1 and LT2, respectively. The word lines WL may be configured as gate electrodes of the memory cell transistors MCT, and the gate upper lines UL1 and UL2 may be configured as gate electrodes of the upper transistors UT1 and UT2, respectively.

In some example embodiments, the lower transistors LT1 and LT2 may include a lower erase control transistor LT1 and a ground select transistor LT2 connected to each other in series. The upper transistors UT1 and UT2 may include a string select transistor UT1 and an upper erase control transistor UT2 connected to each other in series. At least one of the lower erase control transistor LT1 or the upper erase control transistor UT2 may be used in an erase operation for erasing data stored in the memory cell transistors MCT using a GIDL phenomenon.

The common source line CSL, the first and second gate lower lines LL1 and LL2, the word lines WL, and the first and second gate upper lines UL1 and UL2 may be electrically connected to the decoder circuit 1110 through first connection interconnections 1115 extending from the first structure 1100F to the second structure 1100S. The bit lines BL may be electrically connected to the page buffer 1120 through second connection interconnections 1125 extending from the first structure 1100F to the second structure 1100S.

In the first structure 1100F, the decoder circuit 1110 and the page buffer 1120 may perform a control operation on at least one selected memory cell transistor among the plurality of memory cell transistors MCT. The decoder circuit 1110 and the page buffer 1120 may be controlled by the logic circuit 1130. The semiconductor device 1100 may communicate with the controller 1200 through the input/output pad 1101 electrically connected to the logic circuit 1130. The input/output pads 1101 may be electrically connected to the logic circuit 1130 through an input/output connection line 1135 extending from the first structure 1100F to the second structure 1100S.

The controller 1200 may include a processor 1210, a NAND controller 1220, and a host interface 1230. In some example embodiments, the data storage system 1000 may include a plurality of semiconductor devices 1100, and in this case, the controller 1200 may control the plurality of semiconductor devices 1100.

The processor 1210 may control overall operation of the data storage system 1000 including the controller 1200. The processor 1210 may operate according to a desired (and/or alternatively predetermined) firmware, and may access the semiconductor device 1100 by controlling the NAND controller 1220. The NAND controller 1220 may include a controller interface 1221 processing communication with the semiconductor device 1100. Through the controller interface 1221, a control command for controlling the semiconductor device 1100, data to be written to the memory cell transistors MCT of the semiconductor device 1100, and data to be read from the memory cell transistors MCT of the semiconductor device 1100 may be transmitted. The host interface 1230 may provide a communication function between the data storage system 1000 and an external host. When a control command from an external host is received through the host interface 1230, the processor 1210 may control the semiconductor device 1100 in response to the control command.

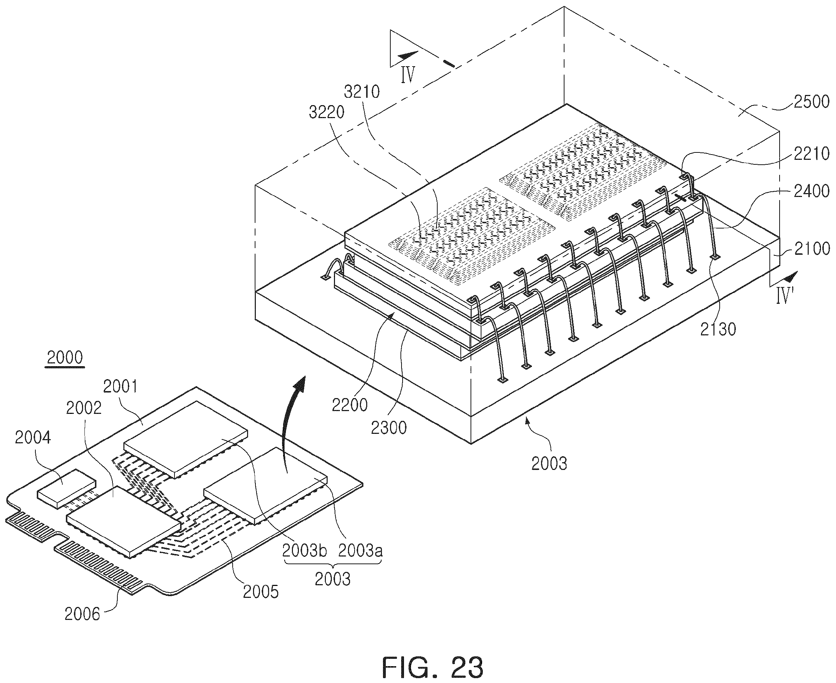

FIG. 23 is a perspective diagram illustrating a data storage system including a semiconductor device according to some example embodiments.

Referring to FIG. 23 a data storage system 2000 in some example embodiments may include a main board 2001, a controller 2002 mounted on the main board 2001, one or more semiconductor packages 2003, and a DRAM 2004. The semiconductor package 2003 and the DRAM 2004 may be connected to the controller 2002 by interconnection patterns 2005 formed on the main board 2001.

The main board 2001 may include a connector 2006 including a plurality of pins coupled to an external host. The number and arrangement of the plurality of pins in the connector 2006 may be varied depending on a communication interface between the data storage system 2000 and the external host. In some example embodiments, the data storage system 2000 may communicate with an external host according to one of interfaces from among universal serial bus (USB), peripheral component interconnect express (PCI-Express), serial advanced technology attachment (SATA), M-Phy for universal flash storage (UFS). In some example embodiments, the data storage system 2000 may operate by power supplied from an external host through the connector 2006. The data storage system 2000 may further include a power management integrated circuit (PMIC) for distributing power supplied from the external host to the controller 2002 and the semiconductor package 2003.

The controller 2002 may write data to or may read data from the semiconductor package 2003, and may improve an operating speed of the data storage system 2000.

The DRAM 2004 may be configured as a buffer memory for alleviating a difference in speeds between the semiconductor package 2003, which is a data storage space, and an external host. The DRAM 2004 included in the data storage system 2000 may operate as a cache memory, and may provide a space for temporarily storing data in a control operation for the semiconductor package 2003. When the data storage system 2000 may include the DRAM 2004, the controller 2002 may further include a DRAM controller for controlling the DRAM 2004 in addition to the NAND controller for controlling the semiconductor package 2003.

The semiconductor package 2003 may include first and second semiconductor packages 2003a and 2003b spaced apart from each other. Each of the first and second semiconductor packages 2003a and 2003b may be configured as a semiconductor package including a plurality of semiconductor chips 2200. Each of the first and second semiconductor packages 2003a and 2003b may include a package substrate 2100, semiconductor chips 2200 on the package substrate 2100, adhesive layers 2300 disposed on lower surfaces of the semiconductor chips 2200, respectively, a connection structure 2400 electrically connecting the semiconductor chips 2200 to the package substrate 2100, and a molding layer 2500 covering the semiconductor chips 2200 and the connection structure 2400 on the package substrate 2100.

The package substrate 2100 may be configured as a printed circuit board including package upper pads 2130. Each semiconductor chip 2200 may include an input/output pad 2210. The input/output pad 2210 may correspond to the input/output pad 1101 in FIG. 22. Each of the semiconductor chips 2200 may include gate stack structures 3210 and channel structures 3220. Each of the semiconductor chips 2200 may include the semiconductor device described in the aforementioned example embodiments with reference to FIGS. 1 to 10.

In some example embodiments, the connection structure 2400 may be configured as a bonding wire electrically connecting the input/output pad 2210 to the package upper pads 2130. Accordingly, in each of the first and second semiconductor packages 2003a and 2003b, the semiconductor chips 2200 may be electrically connected to each other by a bonding wire method, and may be electrically connected to the package upper pads 2130 of the package substrate 2100. In some example embodiments, in each of the first and second semiconductor packages 2003a and 2003b, the semiconductor chips 2200 may be electrically connected to each other by a connection structure including a through-electrode (TSV) instead of the connection structure 2400 of a bonding wire method.

In some example embodiments, the controller 2002 and the semiconductor chips 2200 may be included in a single package. In some example embodiments, the controller 2002 and the semiconductor chips 2200 may be mounted on an interposer substrate different from the main board 2001, and the controller 2002 and the semiconductor chips 2200 may be connected to each other by interconnection formed on the interposer substrate.

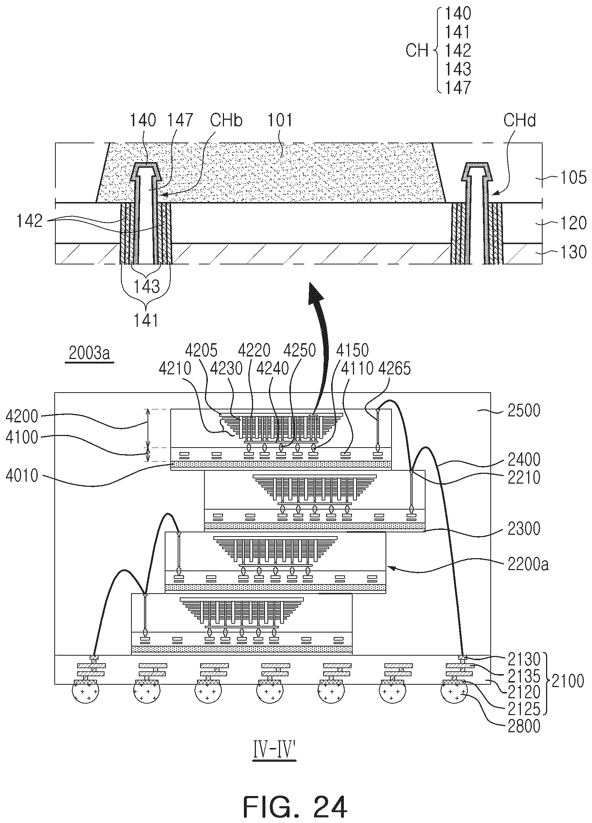

FIG. 24 is a cross-sectional diagram illustrating a semiconductor package according to some example embodiments,

FIG. 24 illustrates some example embodiments of the semiconductor package 2003 in FIG. 23, a region of the semiconductor package 2003 taken along line IV-IV'.

Referring to FIG. 24, in a first semiconductor package 2003a, the package substrate 2100 may be implemented as a printed circuit substrate. The package substrate 2100 may include a package substrate body 2120, package upper pads 2130 disposed on an upper surface of the package substrate body 2120, lower pads 2125 disposed on the lower surface of the package substrate body 2120 or exposed through the lower surface, and internal interconnections 2135 electrically connecting the package upper pads 2130 to the lower pads 2125 in the package substrate body 2120. The package upper pads 2130 may be electrically connected to the connection structures 2400. The lower pads 2125 may be connected to the interconnection patterns 2005 of the main board 2001 of the data storage system 2000 through the conductive connection portions 2800 as illustrated in FIG. 23.

In the first semiconductor package 2003a, each of the first semiconductor chips 2200a may include a semiconductor substrate 4010, a first structure 4100 on the semiconductor substrate 4010, and a second structure 4200 bonded to the first structure 4100 by a wafer bonding method on the first structure 4100.

The first structure 4100 may include a peripheral circuit region including a peripheral interconnection 4110 and first bonding structures 4150. The second structure 4200 may include common source lines 4205, gate electrodes 4210 between the common source lines 4205 and the first structure 4100, memory channel structures 4220 and isolation structure 4230 penetrating gate electrodes 4210, and second bonding structures 4250 electrically connected to word lines (WL in FIG. 1) of the memory channel structures 4220 and the gate electrodes 4210, respectively. For example, the second bonding structures 4250 may be electrically connected to the memory channel structures 4220 and the word lines (WL in FIG. 1) through the gate connection interconnections (e.g., the channel contact plug 170 and/or the channel interconnection lines 180 in FIG. 5A) electrically connected to the bit lines 4240 and the word lines (WL in FIG. 1), respectively. The first bonding structures 4150 of the first structure 4100 and the second bonding structures 4250 of the second structure 4200 may be in contact with and bonded to each other. The bonded portions of the first bonding structures 4150 and the second bonding structures 4250 may be formed of, for example, copper (Cu). However, example embodiments are not limited thereto.

The second structure 4200 may further include data storage patterns 141, 142, and 143 in the channel holes (e.g., first to fourth channel holes CHa-CHd in FIG. 6B), channel pattern 140 surrounded by and extending from the data storage patterns 141, 142, and 143 in the channel holes and extending from the channel holes, and a channel filling insulating layer 147 surrounded by the channel pattern 140. Each of the first semiconductor chips 2200a may further include an input/output pad 2210 and an input/output connection interconnection 4265 below the input/output pad 2210. The input/output connection interconnection 4265 may be electrically connected to a portion of the second bonding structures 4250.

The first semiconductor chips 2200a in FIG. 24 may be electrically connected to each other by connection structures 2400 formed as bonding wires. However, in some example embodiments, semiconductor chips in a semiconductor package, such as the first semiconductor chips 2200a in FIG. 24, may be electrically connected to each other by a connection structure including a through electrode (TSV). However, example embodiments are not limited thereto.

According to the aforementioned example embodiments, a semiconductor device and a data storage system including the same may include channel structures including a plurality of channel holes and a channel pattern connecting the channel holes to each other by using a stopper. Accordingly, a contact failure due to misalignment between the channel structures and a conductive pattern functioning as a common source line in contact with the channel structures may be reduced and/or addressed, thereby providing the semiconductor device having improved reliability and the data storage system including the same.

One or more of the elements disclosed above may include or be implemented in processing circuitry such as hardware including logic circuits; a hardware/software combination such as a processor executing software; or a combination thereof. For example, the processing circuitry more specifically may include, but is not limited to, a central processing unit (CPU) , an arithmetic logic unit (ALU), a digital signal processor, a microcomputer, a field programmable gate array (FPGA), a System-on-Chip (SoC), a programmable logic unit, a microprocessor, application-specific integrated circuit (ASIC), etc.

While some example embodiments have been illustrated and described above, it will be configured as apparent to those skilled in the art that modifications and variations could be made without departing from the scope of the present disclosure as defined by the appended claims.

## Claims

1. A semiconductor device, comprising:
a first semiconductor structure (PERI) including
a substrate (201),
circuit devices (220) on the substrate (201),
a first interconnection structure (270, 280) electrically coupled to the circuit devices (220), and
a first bonding metal layer (298) on the circuit devices (220) and the first interconnection structure (270, 280); and
a second semiconductor structure (CELL) connected to the first semiconductor structure (PERI) on the first semiconductor structure (PERI), the second semiconductor structure (CELL) including
a memory cell substrate including a conductive pattern (101) and an insulating pattern (105) in contact with a side surface of the conductive pattern (101),
gate electrodes (130) stacked and spaced apart from each other in a perpendicular direction (Z) below the memory cell substrate, the perpendicular direction (Z) being perpendicular to a lower surface of the memory cell substrate,
channel structures (CHS) penetrating the gate electrodes (130), extending into the memory cell substrate in the perpendicular direction (Z), and spaced apart from each other in a first direction (X), the first direction (X) intersecting the perpendicular direction (Z),
a second interconnection structure (172, 174) below the gate electrodes (130) and the channel structures (CHS), and
a second bonding metal layer (198) below the second interconnection structure (172, 174),
wherein the second bonding metal layer (198) is connected to the first bonding metal layer (298),
wherein each of the channel structures (CHS) includes
a first channel hole (CHa) penetrating the gate electrodes (130) in the perpendicular direction (Z),
a second channel hole (CHb) penetrating the gate electrodes (130) in the perpendicular direction (Z), the second channel hole (CHb) spaced apart from the first channel hole (CHa), and
a first channel pattern (140) including a first channel portion (140a) in the first channel hole (CHa), a second channel portion (140a) in the second channel hole (CHb), and a first channel connection portion (140b, 140c) extending from the first channel portion (140a) and the second channel portion (140a) on the gate electrodes (130), the first channel connection portion (140b, 140c) connecting the first channel portion (140a) to the second channel portion (140a), and
wherein the conductive pattern (101) does not overlap the first channel hole (CHa) in the perpendicular direction (Z) and overlaps the second channel hole (CHb) in the perpendicular direction (Z).

2. The semiconductor device of claim 1, wherein
each of the channel structures (CHS) further includes
a first data storage pattern (141, 142, 143) in the first channel hole (CHa),
a second data storage pattern (141, 142, 143) in the second channel hole (CHb), and
a channel filling insulating layer (147) surrounded by the first channel pattern (140), and
the first channel connection portion (140b, 140c) extends above the first and second data storage patterns (141, 142, 143).

3. The semiconductor device of claim 2, wherein
the channel filling insulating layer (147) includes
a first insulating portion (147a) surrounded by the first channel portion (140a),
a second insulating portion (147a) surrounded by the second channel portion (140a), and
a third insulating portion (147b) extending from the first insulating portion (147a) and the second insulating portion (147a),
the third insulating portion (147b) connecting the first insulating portion (147a) to the second insulating portion (147a), and
the third insulating portion (147b) surrounded by the first channel connection portion (140b, 140c).

4. The semiconductor device of claim 2 or 3, wherein
the first data storage pattern (141, 142, 143) includes
a first tunneling layer (143) surrounding the first channel portion (140a),
a first data storage layer (142) surrounding the first tunneling layer (143),
a first blocking layer (141) surrounding the first data storage layer (142), wherein the first blocking layer (141) is in contact with the gate electrodes (130), and
the second data storage pattern (141, 142, 143) includes
a second tunneling layer (143) surrounding the second channel portion (140a),
a second data storage layer (142) surrounding the second tunneling layer (143), and
a second blocking layer (141) surrounding the second data storage layer (142),
wherein the second blocking layer (141) is in contact with the gate electrodes (130).

5. The semiconductor device of any one of claims 1 to 4, wherein
the first channel hole (CHa) and the second channel hole (CHb) are spaced apart from each other in a third direction,
the third direction between the first direction (X) and a second direction (Y), and
the second direction (Y) intersecting the first direction (X) and the perpendicular direction (Z).

6. The semiconductor device of any one of claims 1 to 4, further comprising:
a first interconnection (BLa) extending in a second direction (Y), the second direction (Y) intersecting the first direction (X) and the perpendicular direction (Z), the first interconnection (BLa) connected to the first channel hole (CHa); and
a second interconnection (BLc) spaced apart from the first interconnection (BLa) in the first direction (X),
wherein the second interconnection (BLc) is connected to the second channel hole (CHb).

7. The semiconductor device of any one of claims 1 to 6, wherein
the conductive pattern (101) extends in the first direction (X),
a portion of the first channel connection portion (140b, 140c) of the first channel pattern (140) is in contact with the conductive pattern (101), and
another portion of the first channel connection portion (140b, 140c) of the first channel pattern (140) is not in contact with the conductive pattern (101).

8. The semiconductor device of any one of claims 1 to 7, wherein
each of the channel structures (CHS) includes:
a third channel hole (CHc) penetrating the gate electrodes (130) in the perpendicular direction (Z);
a fourth channel hole (CHd) penetrating the gate electrodes (130) in the perpendicular direction (Z) and spaced apart from the third channel hole (CHc); and
a second channel pattern (140) including
a third channel portion (140a) in the third channel hole (CHc),
a fourth channel portion (140a) in the fourth channel hole (CHd), and
a second channel connection portion (140b, 140c) extending from the third channel portion (CHc) and the fourth channel portion (CHd),
wherein the second channel connection portion (140b, 140c) connects the third channel portion (140a) to the fourth channel portion (140a) on the gate electrodes (130),
wherein the third channel hole (CHc) is spaced apart from the first channel hole (CHa) in a second direction (Y), the second direction intersecting the first direction (X) and the perpendicular direction (Z), and
wherein the fourth channel hole (CHd) is spaced apart from the second channel hole (CHb) in the second direction (Y).

9. The semiconductor device of claim 8, wherein the conductive pattern (101) overlaps the third channel hole (CHc) in the perpendicular direction (Z) and does not overlap the fourth channel hole (CHd).

10. The semiconductor device of claim 8 or 9, wherein the first channel pattern (140) and the second channel pattern (140) are spaced apart from each other in the second direction (Y).

11. The semiconductor device of any one of claims 8 to 10, wherein the first channel connection portion (140b, 140c) of the first channel pattern (140) and the second channel connection portion (140b, 140c) of the second channel pattern (140) are connected to and integrated with each other.

12. The semiconductor device of any one of claims 8 to 11, wherein the first to fourth channel holes (CHa, CHb, CHc, CHd) are arranged in a zigzag shape in the second direction (Y).

13. The semiconductor device of any one of claims 1 to 12, wherein each of the channel structures (CHS) further includes a conductive liner (148) covering the first channel connection portion (140b, 140c) of the first channel pattern (140).

14. The semiconductor device of claim 1, further comprising:
a first isolation structure (MS1) and a second isolation structure (MS2);
each of the first and second isolation structures (MS1, MS2) penetrating the gate electrodes (130),
extending in the first direction (X), and
spaced apart from each other in a second direction (Y), the second direction (Y) intersecting the first direction (|X),
wherein the channel structures (CHS) include first channel structures (CH1) spaced apart from each other in the first direction (X) and second channel structures (CH2) spaced apart with the first channel structures (CH1) in the second direction (|Y), and
wherein the first channel structures (CH1) and the second channel structures (CH2) are disposed between the first isolation structure (MS1) and the second isolation structure (MS2).

15. The semiconductor device of claim 1, wherein the insulating patten (105) overlaps the first channel hole (CHa) in the perpendicular direction (Z) and does not overlap the second channel hole (CHb) in the perpendicular direction (Z).
